# EUROPEAN PATENT SPECIFICATION

(11) **EP 1 643 420 B1**
(45) Date of publication and mention of the grant of the patent: **04.08.2010**
(21) Application number: 04746854.1
(22) Date of filing: 25.06.2004
(51) Int. Cl.: G06K 19/00, B42D 15/10, H01L 23/00

(54) **IC CARD AND IC CARD MANUFACTURING METHOD**
CHIPKARTE UND CHIPKARTEN-HERSTELLUNGSVERFAHREN
CARTE A PUCE ET SON PROCEDE DE FABRICATION

(30) Priority: 07.07.2003 JP 2003192614
(43) Date of publication of application: 05.04.2006
(73) Proprietor: Konica Minolta Medical & Graphic, Inc., Tokyo 191-8511 (JP); Dai Nippon Printing Co., Ltd., Shinjuku-Ku Tokyo-To (JP)
(72) Inventor: Takahashi, Hideki, Hino-shi, Tokyo 191-8511 (JP); Hattori, Ryoji, Hino-shi, Tokyo 191-8511 (JP)
(74) Representative: Gille Hrabal Struck Neidlein Prop Roos
(86) International application number: PCT/JP2004/009385
(87) International publication number: WO 2005/004045

(56) References cited:
- JP-A- 8 118 862
- JP-A- 2003 058 847
- JP-A- 2003 132 311
- JP-A- 2003 187 211

## Description

The present invention relates to a non-contact-type electronic card which records personal information requiring security with respect to prevention of such as forgery or alternation, or an IC card incorporated with an IC module comprising an IC chip that is suitably applied to a sheet and an antenna, and an IC card producing method.

As identification card (ID card) or credit card, a magnetic card which records data by means of a conventional magnetic recording method has been commonly utilized. However, magnetic cards had problems of insufficient anti-tampering with data due to the ease of rewriting of the data, of insufficient protection of data due to environmental susceptibility of magnetic record and of insufficient memory capacity. Therefore, IC cards including an IC-chip have become popular in recent years.

An IC card exchanges data with external equipment by reading and writing, through an electric connection provided on the surface or a loop antenna in the card. IC cards are provided with larger memory capacity compared to magnetic cards and have been significantly improved also in security. Particularly, a noncontact-type IC card, which is provided with an antenna inside the card and without having an electric connection outside the card, is superior in security compared to a contact-type IC card which has an electric connection on the card surface, and has become to be utilized in such application as IC card which highly requires secrecy and prevention of forgery or alternation.

As such an IC card, for example, there is known a card in which the first sheet material and the second sheet material are laminated sandwiching an adhesive, and an IC module including an IC-chip and an antenna are sealed in the adhesive layer.

From the view point of the characteristic such as a card, a durability in which it is always carried and which is strong to the pressure such as a repeated bending in pockets of trousers, dropping, or coins, is required. For example, for the durability against damage of an IC chip by pressure, bending, or a breakage of an antenna, for example, it is disclosed in JP-A-6-199083, JP-A-8-324166.

As a technology to solve such a problem, conventionally, it is well known that a strength plate formed of metal or resin is laminated,(for example, refer to JP-A-9-156265, JP-A-9-263082). In this manner, an improvement, such as a strong strength structure provided to the IC chip, is proposed.

However, although an increase of durability of a certain degree can be seen, a sufficient durability to the various conditions can not be obtained, problems in such a manner that, for example, the IC chip is cracked, the card is damaged and the electric motion becomes impossible caused by the damage, are generated to durability to the impulse in which a sudden stress is applied, a repeated bending durability in which stress is repeatedly applied, a repeated local load. Further, not only these durability conditions are improved, but, in order to write the personal information, smooth card surfaces by which no density variation and blurring are obtained in a sublimation printing, melting printing, become necessary.

Furthermore, it is known to seal the surface of a chip arranged on a rigid protective sheet by means of a flexible adhesive layer (JP-A-8-118 862).

The object of the present invention is to provide an IC card whose durability is improved and whose surfaces can be improved in high dimension, and a manufacturing method for such IC card.

This object is attained by an IC card comprising the features of claim 1. Improvements and further features of this IC card are subject matter of claims 2 to 10.

Furthermore, this object is attained by a method of manufacturing such IC card and comprising the features of claim 11.

According to the invention, when the circuit surface side of the IC chip is brought into close contact with the antenna formed on the module support and electrically connected to it, and the circuit surface side of the IC chip protects the IC chip with the module support, and even when the thickness is the same, two reinforcing plates are provided comparing to one reinforcing plate, the stress is distributed and the IC chip can be protected from damaging.

When the first reinforcing plate is larger than the area of the IC chip and its outer periphery, and the second reinforcing plate is larger than the area of the first reinforcing plate and its outer periphery, because the weight when bent or pushed is easily applied to the second reinforcing plate whose size is largest, and it is easily broken, the durability of the IC chip is improved.

If the area and outer periphery of the close contacting agent are larger than the second reinforcing plate and the IC chip is sealed by the close contacting agent, there is no air gap and the durability is improved, the concave and convex property is lowered, and an IC chip part is smoothly formed on the module support, and the smooth card surface can be obtained.

When the 2 % elastic modulus is less than 55.0 kg/mm², it is excellent to absorb the stress, and it more protects the IC chip from being broken, when more than 0.1 kg/mm², the self-support property is more increased, the integration with the reinforcing plate is increased, and the IC chip damage protection effect becomes high.

If according to the invention the IC chip is provided between the module support and the first reinforcing plate the IC chip can be protected from breaking by this module support and the reinforcing plate. When the thickness of the IC chip is more than 30 µm less than 190 µm, and the thickness of the close contacting agent is more than 1 µm less than 50 µm, if the chip is thick, the circuit of the chip is easily broken by the bending stress, and if it is too thin, the chip is easily cracked by the local stress. Further, when the close contacting agent is too thick, the reinforcing effect is lowered and the strength is decreased even when a highly strong reinforcing plate is adjoined, and inversely, when it is too thin, the effect of the close contacting agent which has the stress softening function is decreased, and the chip becomes weak to the stress such as bending, so that when the thickness of the IC chip and the thickness of the close contacting agent are as prescribed, the durability can be improved.

According to the invention the maximum thickness of the IC module is the upper surface on the reinforcing plate side of the IC chip from the module support which is opposite to the circuit surface side. When the module support is too thin, the antenna is easily broken, when it is too thick, the IC card becomes thick, and when the IC chip part of the IC module is too thick, the IC chip is easily cracked by the local stress. When the thickness of the module support in which the antenna is formed, and the maximum thickness of the IC chip part of the IC module are prescribed, the durability can be improved.

If according to the invention the first reinforcing plate is circular or square, and the second reinforcing plate is square, the center of gravity may be deviated between the first reinforcing plate and the second reinforcing plate. However, because the outmost layer is easily broken when external stress such as bending deformation is applied, the reinforcing plate of the outmost layer is separated from the center of gravity. When the reinforcing plates have almost the same center of gravity, the IC chip can be protected.

According to the invention personal identification information composed of name and face image is fusing heat transferred or sublimation heat transferred onto the image-receiving layer, and information recording having no density variation and blurring can be conducted.

When the 2% elasticity of the adhesive agent is less than 80 kg/mm², it is excellent in absorption of stress, and the IC module is more protected from breaking, and when more than 1kg/mm², self-supportability is more increased, the integration with the IC module is increased, and the break effect of the IC module is high.

According to the method of the invention the IC card, in which, after the terminal for connection provided on the IC chip circuit surface is electrically connected onto the module support, the first reinforcing plate is pressure-heat close contacted, and the second reinforcing plate is pressure-heat close contacted, and the IC module is made, and the IC module is placed between opposing two base members and the adhesive agent is filled, and pressure-close contacted, and the external force is stress-distributed, and the IC chip can be protected from breaking, can be manufactured.

In the drawings
Fig. 1 is a view showing a layer construction of an IC-card according to the present invention,
Fig. 2 is a side view of an IC module according to the present invention,
Fig. 3 is a plane view of an IC module according to the present invention,
Figs. 4(a) and 4(b) show a side view of an IC module according to the present invention,
Fig. 5 is a side view of an IC module according to the present invention,
Fig. 6 is a plane view of an IC chip section according to the present invention,
Fig. 7 is a plane view of an IC chip section according to the present invention,
Fig. 8 is a plane view of an IC chip section according to the present invention,
Fig. 9 is a plane view of an IC chip section according to the present invention,
Fig. 10 is a side view of an IC module according to a comparative example,
Fig. 11 is a side view of an IC module according to a comparative example,
Fig. 12 is a drawing showing a layer construction of an IC-card according to a comparative example,
Fig. 13 is a side view of an IC module according to a comparative example,
Fig. 14 is a drawing showing a layer construction of an IC-card according to a comparative example,
Fig. 15 is a side view of an IC module according to a comparative example,
Fig. 16 is a drawing showing a situation to protect an IC module of the present invention,
Fig. 17 is a drawing showing a situation to protect an IC module of the present invention,
Fig. 18 is a perspective view showing an entire outline of a punching die apparatus and
Fig. 19 is a front end view of a main part of the punching die apparatus.

Based on the drawings, an embodiment of the IC card of this invention and the IC card manufacturing method is detailed below, however, this invention is not limited to this embodiment. Further, the embodiment of this invention shows the most preferable embodiment, and terms of this invention are not limited to this embodiment.

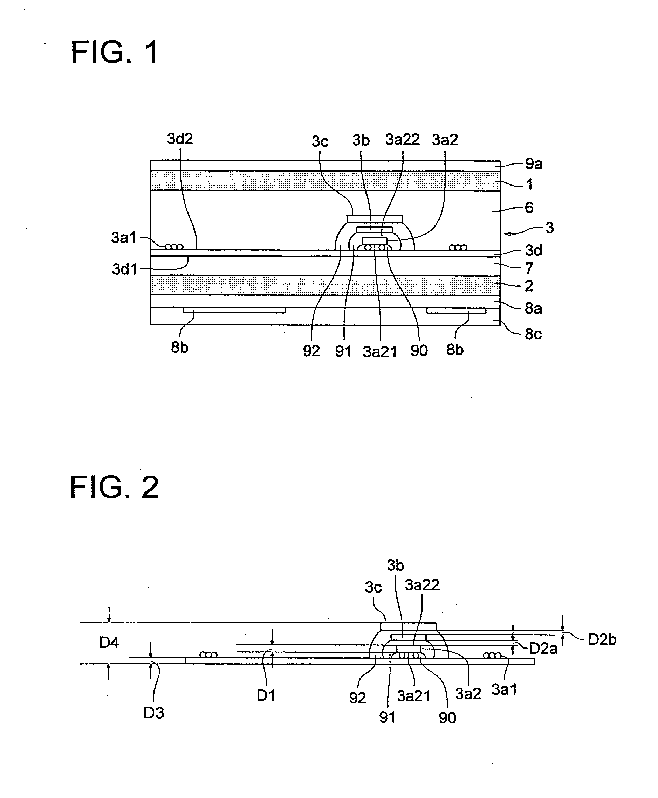

Initially, the IC card of this invention will be described. Fig. 1 is a view showing the layer structure of , the IC card.

The IC card of this embodiment can be widely applied to an ID card or a credit card, and parts including the IC module 3 in which, between opposing 2 base member 1 and base member 2, the reverse adhesive agent 6 and the obverse adhesive agent 7 are provided, and which has an antenna 3a1, the IC chip 3a2, and the module support 3d, are arranged.

The reverse adhesive agent 6 and the obverse adhesive agent 7 are same composition, and the 2 % elasticity of these adhesive agents are more than 1 less than 80 kg/mm². When the 2% elasticity is more than 80 kg/mm², it can not absorb the stress, and the IC module 3 is broken, when less than 1 kg/mm², self support property is lowered, and the integration with the IC module 3 is lowered, the IC module 3 is broken, however, when it is fixed through an adhesive agent of prescribed 2 % elasticity, the IC module 3 can be protected from breaking.

To one side reverse base member 1, the writing layer 9a on which the writing can be conducted, is provided. To the other obverse base member 2, the image receiving layer 8a is provided, and on this image receiving layer 8a, the name, an authorization image which is the personal identification information including a face image, an attribute information 8b are recorded. To the image receiving layer 8a, a protective layer for protecting the authorization image which is a personal identification information, and the attribute information 8b, is provided, and when this protective layer 8c is provided, the durability from the wear or medicines, or against the pressure of dropping, coins, is improved. To this image receiving layer 8a, the personal identification information formed of the name, face image, is provided by fusing-heat transfer, or sublimation heat transfer, and the information recording having no density variation and blurring can be conducted.

This antenna 3a1, IC chip 3a2 are provided on the module support 3d, and the module support 3d is structured by film. To the module support 3d, the circuit surface 3a21 of the IC chip 3a2 and the antenna 3a1 are electrically connected through the conductive adhesive agent 90.

To the circuit surface 3a21 of this IC chip 3a2 and the opposite side 3a22, the first reinforcing plate 3b is connected through the close contacting agent 91, and to this first reinforcing plate 3b, the second reinforcing plate 3c is connected through the close contacting agent 92. In this manner, the IC card has the first reinforcing plate 3b, the second reinforcing plate 3c in such a manner that they are adjoined through the close contacting agents 91, 92 on the opposite side to the circuit surface 3a21 of the IC chip 3a2, and has them in this order.

In the present embodiment, this close contacting agent 91 and the close contacting agent 92 are same composition, however, this close contacting agent 91 and the close contacting agent 92 may also be same or different. The close contacting agent 91 is provided on the module support 3d so as to surround the IC chip 3a2, and the first reinforcing plate 3b to the IC chip 3a2 through the close contacting agent 91. The close contacting agent 92 is provided on the module support 3d so as to surround the IC chip 3a2 and the first reinforcing plate 3b, and the second reinforcing plate 3c is connected to the first reinforcing plate 3b through the close contacting agent 92.

As described above, the circuit surface side of the IC chip 3a2 is close contacted with the antenna 3a1 formed on the module support 3d and electrically connected to it through the conductive adhesive agent 90, and the circuit surface side of the IC chip 3a2 protects the IC chip 3a2 with the module support 3d. The opposite side 3a22 to the circuit surface side of the IC chip 3a2 has the first reinforcing plate 3b, the second reinforcing plate 3c through the close contacting agents 91, 92, and the IC chip 3a2 is strongly protected with 2 sheets of reinforcing plates, and the stress are distributed, hereby, the IC chip 3a2 can be protected from breaking.

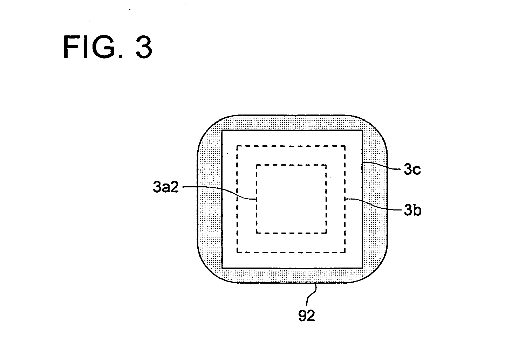

This IC module 3 is structured as shown in Fig. 2 and Fig. 3. Fig. 2 is a side view of the IC module, and Fig. 3 is a plan view of the IC chip part.

In the IC module 3 of this embodiment, the first reinforcing plate 3b is larger than the projected area in the direction perpendicular to the IC card surface of the IC chip of the IC chip 3a2 and the outer periphery, and the second reinforcing plate 3c is larger than the area and the outer periphery of the first reinforcing plate. In this manner, when the first reinforcing plate 3b is larger than the area and the outer periphery of the IC chip 3a2 and the second reinforcing plate 3c is larger than the area and the outer periphery of the first reinforcing plate 3b, the load when it is bent or pushed, is easily applied to the largest second reinforcing plate 3c and it is easily broken. Further, the IC chip 3a2 is protected by the first reinforcing plate 3b, and the durability of the IC chip 3a2 is improved.

Further, the area and the outer periphery of the close contacting agent 92 are larger than the second reinforcing plate 3c, and IC chip 3a2 is shield by the close contacting agent 92, the IC chip part is smoothly formed on the module support 3d, and a smooth card surface can be obtained.

The IC chip 3a2, the first reinforcing plate 3b and the second reinforcing plate 3c of this embodiment are fixed through the close contacting agents 91, 92 whose 2 % elastic module is more than 0.1 less than 55.0 kg/mm². When the 2 % elastic module is more than 55.0 kg/mm², the stress can not be absorbed, and the IC chip 3a2 is broken, and when it is less than 0.1 kg/mm², the self-supportability is lowered, and the integration of the first reinforcing plate 3b with the second reinforcing plate 3c is lowered, and the IC chip 3a2 is broken, however, when they are fixed through the close contacting agents 91, 92 whose 2 % elastic module is more than 0.1 less than 55.0 kg/mm², the breakage of the IC chip 3a2 can be prevented.

Further, in this embodiment, the IC module 3 is provided in such a manner that it has the image receiving layer 8a at least on one side of the obverse and reverse, and on the other side, it has the writing layer 9a, and the base member surface 3d1 in which the IC chip 3a2 of the module support 3d is not mounted, is on the image receiving layer 8a side, and the base member surface 3d2 in which the first reinforcing surface 3b, the second reinforcing surface 3c are mounted, is on the writing layer 9a side. The IC chip 3a2 is provided among the module support 3d, and the first reinforcing plate 3b, the second reinforcing plate 3c, and the IC chip 3a2 can be protected from the breaking by this module support 3d and reinforcing plates.

In this embodiment, the thickness D1 of the IC chip 3a2 is more than 30 µm less than 190 µm, and the thickness of the close contacting agents 91, 92 are more than 1 µm less than 50 µm. When the IC chip 3a2 is thick, the circuit of the chip is easily broken against the bending stress, and when it is too thin, the chip is easily cracked by the local stress. Further, when the close contacting agent is too thick, the reinforce effect is lowered and the strength is lowered, even when the highly strong reinforcing plate is adjoined, inversely, when it is too thin, the effect of the close contacting agent which has together the stress softening function is reduced, and the IC chip becomes weak against the stress such as the bending, and when the thickness of the IC chip 3a2 and the thickness of the close contacting agents 91, 92 are prescribed, the durability can be improved.

Herein, the thickness of the close contacting agent is an interval in which the IC chip and the first reinforcing plate are separated by the close contacting agent, or an interval in which the first reinforcing plate and the second reinforcing plate are separated by the close contacting agent. Accordingly, the thickness of the close contacting agent 91 is shown by D2a in Fig. 2. Further, the thickness of the close contacting agent 92 is shown by D2b in Fig. 2. When the thickness of the close contacting agent is not uniform by the relative positional relationship with the IC chip and the first reinforcing plate, or the first reinforcing plate and the second reinforcing plate, it is defined as the average of the thickness of a plurality of positions.

Further, the thickness D3 of the module support 3d in which the antenna 3a1 is formed, is more than 10 µm less than 50 µm, the maximum thickness D4 of the IC chip part of the IC module 3 is less than 350 µm. The maximum thickness D4 of the IC chip part of the IC module 3 is the upper surface on the reinforcing plate side of the IC chip from the module support surface which is opposite to the circuit surface side. When the module support 3d is too thin, the antenna 3a1 is easily broken, when it is too thick, the IC card becomes thick, when the IC chip part of the IC module 3 is too thick, the IC card is easily cracked by the local stress, and when the thickness D3 of the module support d3 in which the antenna 3a1 is formed, and the maximum thickness D4 of the IC chip part of the IC module 3 are prescribed, the durability can be improved.

In this embodiment, in the plane as can be seen in Fig. 3, the center of gravity position of the first reinforcing plate 3b, and the second reinforcing plate 3c and the center of gravity position of the IC chip 3a2 are almost the same, and in the reinforcing plate shape, the first reinforcing plate 3b is a square formed of metal, and the second reinforcing plate 3c is a square formed of metal. This first reinforcing plate 3b may be circular.

In the reinforcing plate shape, the first reinforcing plate 3b is circular or square, the second reinforcing plate is square, and further, as the side-edge part of the second reinforcing plate is placed in a position separated from the center of gravity (for example, as the diagonal line is long), the outmost layer is easily broken, when the external stress such as bending deformation is applied (in the case of this embodiment, because the second reinforcing plate is broken going ahead of the first reinforcing plate which is near the IC chip), as the result, the IC chip 3a2 can be protected.

In the manufacturing of this IC card, as shown in Fig. 2 and Fig. 3, the IC module 3 is produced in such a manner that: after the bump for connection provided on the IC chip circuit surface is electrically connected to the antenna 3a1 provided on the module support 3d by the anisotropy conductive adhesive agent, the close contacting agent 91 is provided by potting, and the first reinforcing plate 3b is pressure-heat adhered, and further, the close contacting agent 92 is provided by potting, and the second reinforcing plate 3c is pressure-heat adhered.

The IC card by which the external force is stress-distributed, and the IC chip 3a2 can be protected from the breakage, can be manufactured when the produced IC module 3 is placed at a predetermined position between the reverse base member 1 and the obverse base member 2 which are opposing 2 base members, and the reverse adhesive agent 6 and the obverse adhesive agent 7 are filled and pressure-adhered.

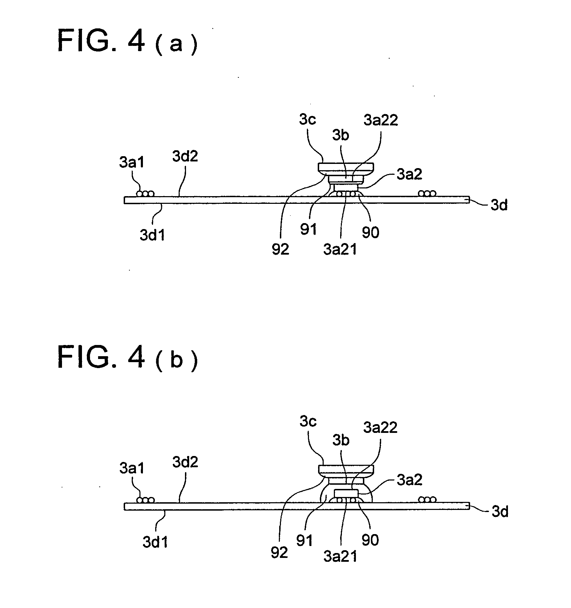

Next, the other embodiment of the IC module 3 will be shown in Fig. 4(a) and Fig. 4(b). Fig. 4(a) and Fig. 4(b) are both side views of the IC module. This embodiment is structured in the same manner as the IC module 3 in Fig. 1 to Fig. 3, however, and the projected area in the direction perpendicular to the IC card plane of the IC chip of the close contacting agent 92, and the outer periphery are smaller than the second reinforcing plate 3c, and the close contacting agent 92 is provided between the first reinforcing plate 3b and the second reinforcing plate 3c.
In the close contacting agent 91 of this embodiment, in Fig. 4(a), the projected area in the direction perpendicular to the IC card plane of the IC chip of the close contacting agent 91, and the outer periphery are smaller than the first reinforcing plate 3b, and the close contacting agent 91 is provided between the first reinforcing plate 3b and the IC chip 3a2, and provided so as not to shield the IC chip 3a2, however, in Fig. 4(b), the projected area in the direction perpendicular to the IC card plane of the IC chip of the close contacting agent 91, and the outer periphery are larger than the first reinforcing plate 3b, and the close contacting agent 91 is provided between the first reinforcing plate 3b and the IC chip 3a2, and provided so as to seal the IC chip 3a2.

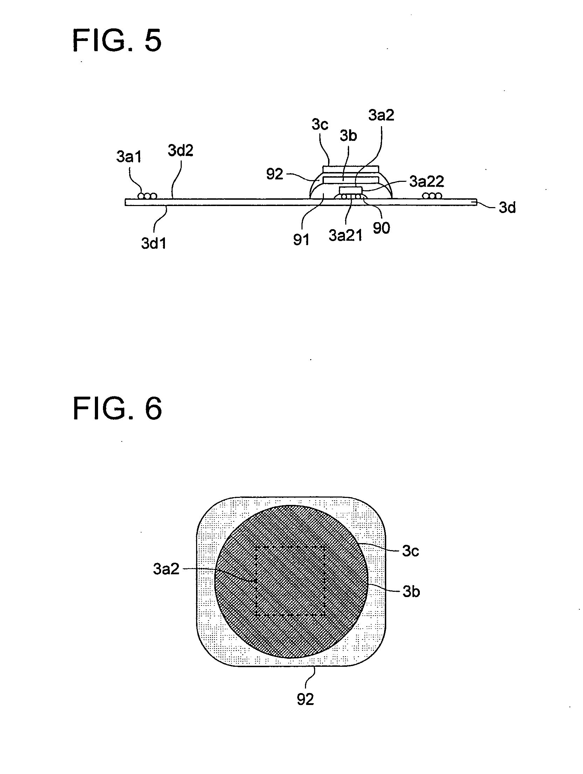

Further, the other embodiment of the IC module 3 will be shown in Fig. 5. Fig. 5 is a side view of the IC module. This embodiment is structured in the same manner as the IC module 3 in Fig. 1 to Fig. 3, and the first reinforcing plate 3b and the second reinforcing plate 3c are formed into the same shape.

Further, the other embodiment of the IC module 3 will be shown in Fig. 6. Fig. 6 is a plan view of the IC chip part of the IC module. This embodiment is structured in the same manner as the IC module 3 in Fig. 1 to Fig. 3, and the first reinforcing plate 3b and the second reinforcing plate 3c are formed into the same circular shape.

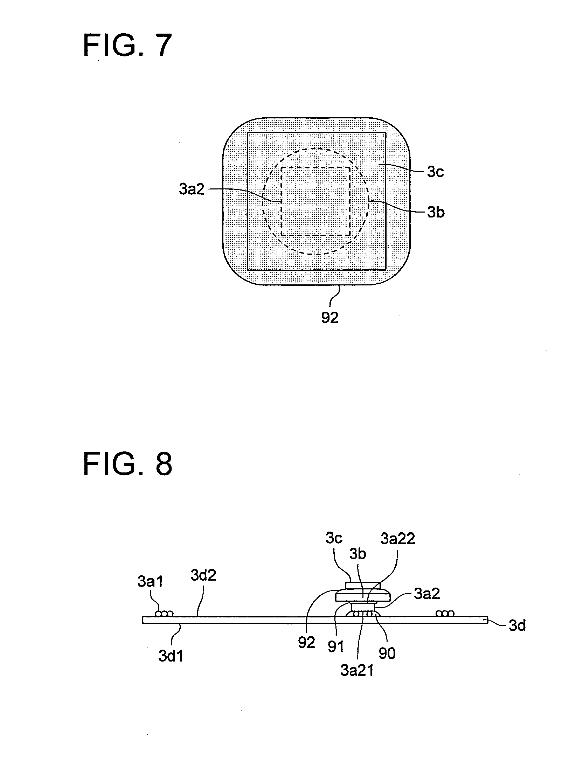

Further, the other embodiment of the IC module 3 will be shown in Fig. 7. Fig. 7 is a plan view of the IC chip part of the IC module. This embodiment is structured in the same manner as the IC module 3 in Fig. 1 to Fig. 3, and the first reinforcing plate 3b is circular, and the second reinforcing plate 3c is a square, and the second reinforcing plate 3c is formed larger than the first reinforcing plate 3b.

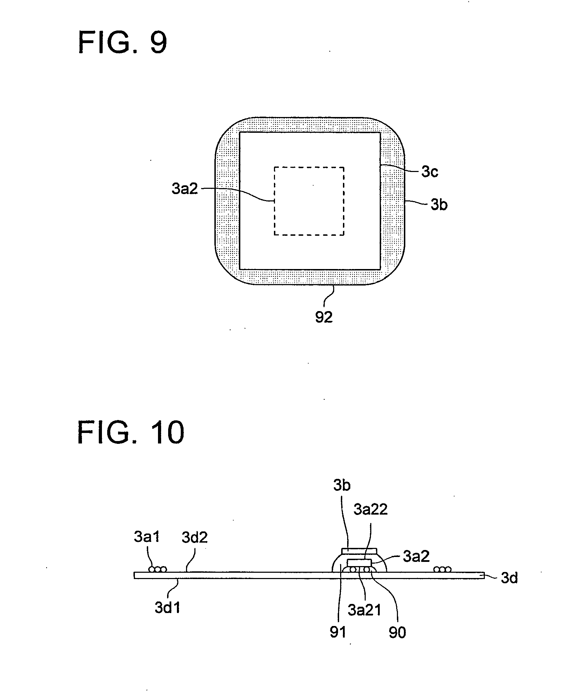

Further, the other embodiment of the IC module 3 will be shown in Fig. 8 and Fig. 9. Fig. 8 is a side view of the IC module, and Fig. 9 is a plan view of the IC chip part of the IC module. This embodiment is structured in the same manner as the IC module 3 in Fig. 4, and the second reinforcing plate 3c is formed smaller than the first reinforcing plate 3b. In this embodiment, the first reinforcing plate 3b and the second reinforcing plate 3c are same square, as shown in Fig. 9, but may also be circular, and square and circular.

Next, an embodiment of the IC module of a comparative example will be shown in Fig. 10. Fig. 10 is a side view of the IC module of a comparative example. The IC module of this comparative example is structured in the same manner as the IC module 3 shown in Fig. 1 to Fig. 3, however, the first reinforcing plate 3b is only provided, and the close contacting agent 92 and the second reinforcing plate 3c are not provided.

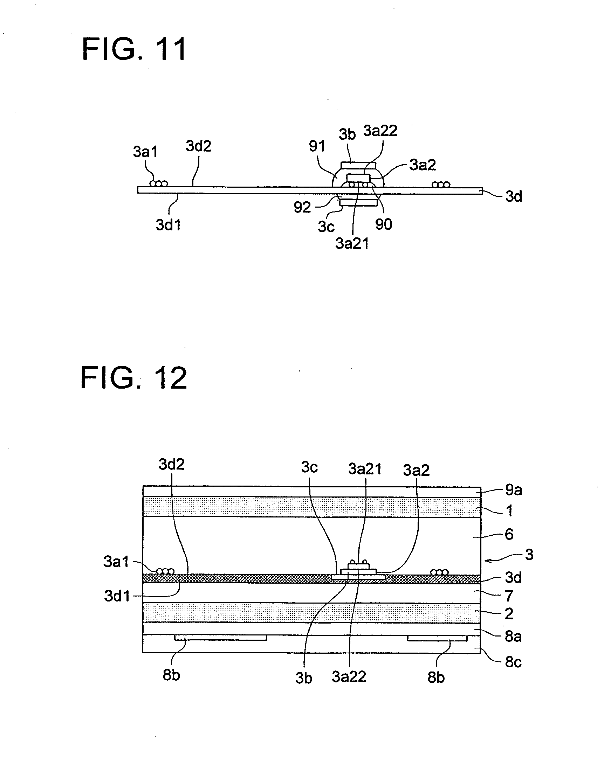

Next, an embodiment of the IC module of a comparative example will be shown in Fig. 11. Fig. 11 is a side view of the IC module of a comparative example. The IC module of this comparative example is structured in the same manner as the IC module 3 shown in Fig. 1 to Fig. 3, however, the second reinforcing plate 3c is provided on the surface of the opposite side to the surface on which the IC chip 3a2 of the module support 3d or the first reinforcing plate 3b is provided.

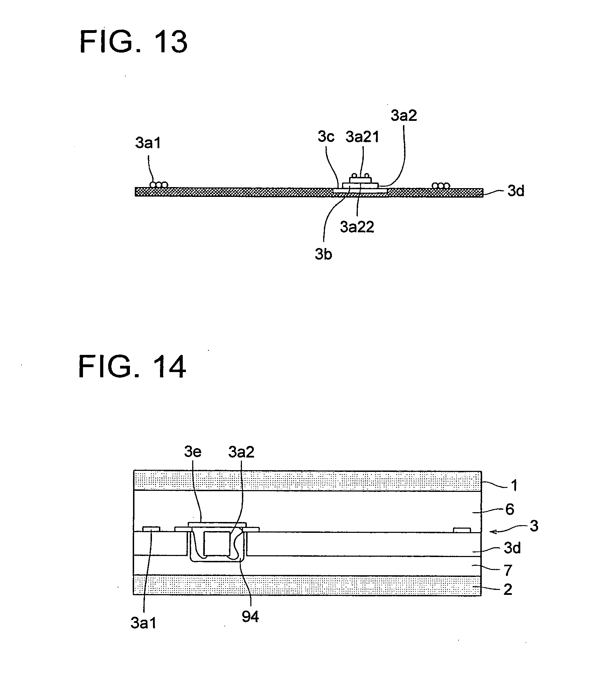

Next, an embodiment of the IC module of an another comparative example will be shown in Fig. 12 and Fig. 13. Fig. 12 is a view showing a layer structure of the IC card of a comparative example, and Fig. 13 is a side view of the IC module of the comparative example.

The layer structure of the IC card of this embodiment is structured in the same manner as in the embodiment of Fig. 1, and the IC module 3 adjoins the first reinforcing plate 3b, the second reinforcing plate 3c on the opposite side to the circuit surface 3a21 of the IC chip 3a2 through the close contacting agents 91, 92, and has them in this order, however, the opposite side of the circuit surface 3a21 of the IC chip 3a2 is provided on the module support 3d, and the circuit surface side of the IC chip 3a2 is arranged as the writing layer 9a side.

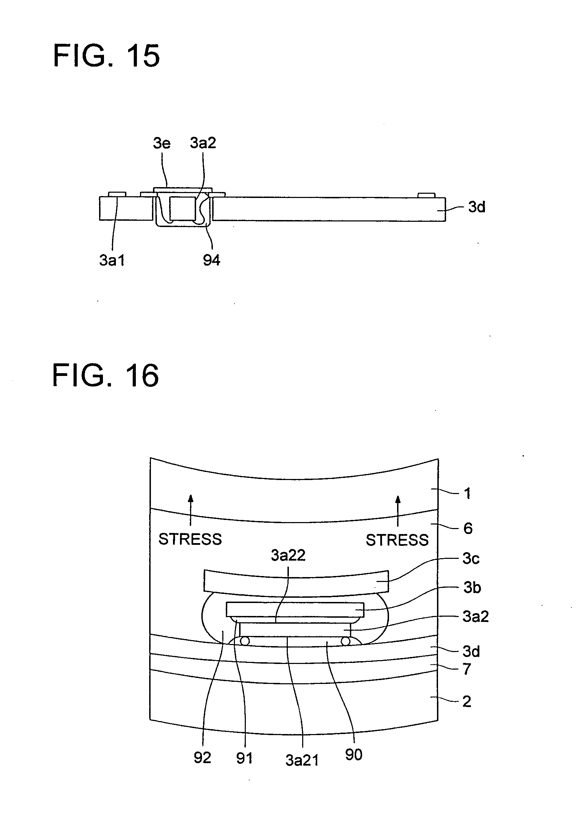

Next, the embodiment of the IC module of the other comparative example will be shown in Fig. 14 and Fig. 15. Fig. 14 is a view showing a layer structure of the IC card of a comparative example, and Fig. 15 is a side view of the IC module of the comparative example.

The layer structure of the IC card of this embodiment is structured in the same manner as in the embodiment of Fig. 1, and in the IC module 3, the module support 3d is a resin sheet, and for example, PET-G sheet is used. In this resin sheet, the antenna 3a1 is formed. The IC chip 3a2 is fixed to a lead frame 3e, and this lead frame 3e is fixed to the module support 3d by the close contacting agent 94.

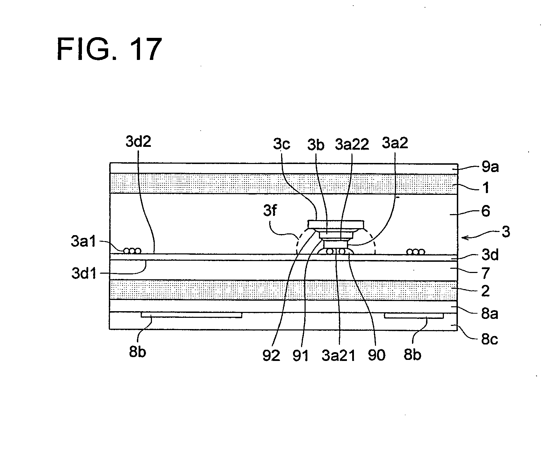

To such comparative examples, in the embodiment of this invention, there are effects as shown in Fig. 16 and Fig. 17.

As shown in Fig. 16, in the case where the stress is applied to the IC card, when the first reinforcing plate 3b is larger than the area and the outer periphery of the IC chip 3a2, and the second reinforcing plate 3c is larger than the area and the outer periphery of the first reinforcing plate 3b, a load when it is bent or pushed, is easily applied to the largest second reinforcing plate 3c, and because the breakage is advanced from the second reinforcing plate 3c, the IC chip 3a2 is protected and the durability of the IC chip 3a2 is improved.

Further, as shown in Fig. 17, when the IC chip 3a2 is not sealed by the close contacting agent 92 and the area of the close contacting agent 92 is small, it easily becomes a air gap 3f, and the durability and concave-convex property are easily lowered, however, when the area and the outer periphery of the close contacting agent 92 are larger than the second reinforcing plate 3c and the IC chip 3a2 is sealed by the close contacting agent 92, the air gap 3f is deleted, and the durability is improved and the concave-convex property is lowered, and the IC chip part is smoothly formed on the module support 3d, resulting in obtaining the smooth card surface.

Hereinafter, an IC card and an IC card producing method according to the present invention will be explained.

### <Measurement method of 2% module of elasticity>

As a measurement method of 2% module of elasticity, an adhesive of 500 µm thick was cured to prepare an adhesive sheet, and utilizing the adhesive sheet, tensile module of elasticity and tensile break point elongation were measured by use of Tensilon Universal Tester produced by Orientech Co., Ltd. according to ASTM D638.

### [Base member]

Examples of an obverse side base member and a reverse side base member include a single-layered member comprised of synthetic resin sheets of such as polyester resins such as polyethylene terephthalate, polybutylene terephthalate, and a polyethylene terephthalate/iso-phthalate copolymer; polyolefin resins such as polyethylene, polypropylene and polymethyl pentene; polyethylene fluoride type resins such as polyvinyl fluoride, polyvinylidene fluoride, polyethylene tetrafluoride and an ethylene/tetrafluoroethylene copolymer; polyamides such as 6-nylon, 6,6-nylon; vinyl polymers such as polyvinyl chloride, a vinyl chloride/vinyl acetate copolymer, an ethylene/vinyl acetate copolymer, an ethylene/vinyl alcohol copolymer, polyvinyl alcohol, vinylon; biodegradable resins such as biodegradable aliphatic polyester, biodegradable polycarbonate, biodegradable polylactic acid, biodegradable polyvinyl alcohol, biodegradable cellulose acetate and biodegradable polycaprolactone; cellulose-type resins such as cellulose triacetate and cellophane; acryl-type resins such as polymethyl methacrylate, polyethyl methacrylate, polyethyl acrylate and polybutyl acrylate; polystylene; polycarbonate; polyallylate and polyimide; or of paper such as wood free paper, thin leaf paper, grassine paper and sulfuric acid paper; and of metal foil; or multilayered member in which two or more members thereof are accumulated. The thickness of a base member of the invention is from 30 to 300 µm and preferably from 50 to 200 µm. In case of 50 µm or less, it may be problem that, because there may be thermal shrinkage at the time of laminating the obverse side base member and the reverse side base member together.

In the invention, a coefficient of thermal shrinkage is preferably not more than 1.2% in a longitudinal direction (MD) and not more than 0.5% in a width direction (TD) at 150 °C/30 min. Since it was difficult to register in the following cutting process and printing process due to thermal shrinkage having been caused by temperature in case that an adhesive was coated or laminated for production from both surface sides of the obverse side base member and the reverse side base member, it is preferred to cause no shrinkage of the base members by utilizing an adhesive, which adheres at low temperatures, and a base member, having a coefficient of thermal shrinkage of not more than 1.2% in a longitudinal direction (MD) and not more than 0.5% in a width direction (TD) at 150 °C/30 min.

In the invention, preferably utilized is a base member, which is prepared by blending with a white pigment to improve opacity and by being annealed to depress a thermal shrinkage percentage, having a thermal shrinkage percentage of not more than 1.2% in a longitudinal direction (MD) and not more than 0.5% in a width direction (TD) at 150 °C/30 min. The above-described after processes were proved to become difficult due to shrinkage of a base member when a thermal shrinkage percentage is not less than 1.2% in a longitudinal direction (MD) and not less than 0.5% in a width direction (TD). Further, on the above-described base member, adhesion enhancing treatment for improving adhesion in the post process or anti-static treatment for chip protection may have been provided.

Concretely, U2 Series, U4 Series and UL Series manufactured by Teijin Dupont Film Co., Ltd.; Clisper G Series manufactured by Toyobo Co., Ltd.; and E00 Series, E20 Series, E22 Series, X20 series, X40 Series, E60 Series and QE Series manufactured by Toray Industries, Inc. can be suitably utilized.

The second base member of the obverse side base member may be optionally provided with an image receiving layer and a cushion layer to form a face image of the card user. An image element is provided on the surface of a personal certification card base, and preferably includes at least one selected from a certifying identification image such as a face image, an attributing information image and format print.

For an image receiving layer, resins well known in the art can be utilized and examples include polyvinyl chloride resins, copolymer resins of vinyl chloride and other monomers (such as isobutylether and vinylpropionate), polyester resins, poly(metha)acrylate esters, polyvinylpyrrolidone, polyvinylacetal-type resins, polyvinylbutyral-type resins, polyvinylalcohol, polycarbonate, cellulose triacetate, polystyrene, copolymers of styrene and other monomer (such as acrylate ester, acrylonitrile and ehtylene chloride), vinyltolueneacrylate resins, polyurethane resins, polyamide resins, urea resins, epoxy resins, phenoxy resins, polycaprolactone resins, polyacrylonitrile resins and modified compounds thereof, and preferable are polyvinyl chloride resins, copolymers of vinyl chloride and other monomers, polyester resins, polyvinylacetal-type resins, polyvinylbutyral-type resins, copolymers of styrene and other monomers and epoxy resins.

### <Cushion Layer>

Polyolefin is preferable as a material to form a cushion layer of the invention. For example, such as polyethylene, polypropyrene, an ethylene-vinyl acetate copolymer, an ethylene-ethylacrylate copolymer, a styrenebutadiene-styrene block-copolymer, a styrene-isoprene-styrene block-copolymer, a styrene-ethylene-butadiene-styrene block-copolymer, a styrene-hydrogenated isoprene-styrene block-copolymer, polybutadiene and a photo-curable resin; having flexibility and a low thermal conductivity are suitable. Concretely a cushion layer such as described in Japanese Patent Application No. 2001-16934 can be utilized.

A cushion layer referred in the invention means a soft resin layer, which is located between a base member and an image receiving layer accepting an image, and functions to relax the effect of roughness caused by an electronic part such as an IC module.

The cushion layer is not particularly limited provided that it is of an embodiment locating a cushion layer between an image receiving layer and an electronic part, however, is specifically preferably formed being coated or laminated on one or both of the surfaces of a base member.

### <Writing Layer>

A writing layer is a layer which is made to be writable on the back-side of an IC card. Such a writing layer can be formed, for example, by including inorganic fine particles of such as calcium carbonate, talc, diatomaceous earth, titanium oxide and barium sulfate in a film of a thermoplastic resin (e.g. a polyolefin series such as polyethylene, and various kinds of copolymers). It can be formed according to "a write-in layer" described in JP-A (Hereinafter, JP-A refers to Japanese Patent Publication Open to Public Inspection) No. 1-205155. The above-described writing layer is formed on the surface, on which plural layers are not accumulated, of a base member.

### <Adhesive>

As a hot-melt adhesive for an IC card of the invention, ones commonly used can be uttilized. A main component of a hot-melt adhesive includes, for example, an ethylenevinylacetate copolymer (EVA) type, a polyester type, a polyamide type, a thermoplastic elastomer type, a polyolefin type, etc. However, in the invention, a card is liable to curl or a layer such as an image receiving layer for image formation by means of thermal transfer, being provided on a card surface and weak in a high temperature process, may be damaged. Further, when being laminated via adhesive, the base members are preferably laminated at not higher than 80 °C, more preferably from 10 to 80 °C and furthermore preferably from 20 to 80 °C, in respect to problems in that base members cause thermal shrinkage due to a high temperature lamination, resulting in poor dimensional and positional precision at the time of lamination. Among low temperature hot-melt adhesives, concretely, a reactive type hot-melt adhesive is preferable. A reactive type hot-melt adhesive (hereinafter, called as a reactive adhesive) is a adhesive of the type which resin hardens by absorbing moisture, after gluing by melting the resin. As a distinctive feature, since it has a cure reaction as compared with the usual hot melt, adhesion possibility time is long as it requires for it, and since softening temperature becomes high after adhesion, it is rich in durability and it may be suitable for processing at low temperature.

As one example of reactive adhesive, there may be an adhesive in which isocyanate group containing polyurethane polymer at its molecule trailing end is contained as a main ingredient and this isocyanate group reacts with a water content so as to form a structure of cross linkage. As the reactive adhesive which can be used for this invention, TE030 and TE100 produced by Sumitomo 3M, Hybon 4820 produced by Hitachi Chemical polymer company, and Bondmaster 170 series produced by Kanebo NSC, Macroplast QR 3460 produced by Henkel may be listed.

As a reactive hot-melt adhesive, materials of a moisture curable type are disclosed in JP-A Nos. 2000-036026, 2000-219855, 2000-211278 and 2000-219855, and Japanese Patent Application No. 2000-369855. Photo-curable adhesives are disclosed in JP-A Nos. 10-316959 and 11-5964.

Any of these adhesive may be used, and unlimited materials are preferably utilized in the invention.

A layer thickness of an adhesive, provided being in a range of the invention, is preferably from 10 to 600 µm, more preferably from 10 to 500 µm and furthermore preferably from 10 to 450 µm, based on a thickness including the electronic part.

In this invention, when the adhesive agent whose elastic modulus is in the range of 1 - 80 kg/mm² and low, is used, the stress is softened and the high durability can be obtained. When the elastic modulus is more than 80 kg/mm², the stress can not be absorbed, and the IC chip is broken. When the elastic modulus is less than 1 kg/mm², the self-base memberability is lowered, the stress is concentrated in the chip, resulting in the breakage of IC chip.

Further, a ratio (m)/(s) of the elastic modulus (m) of the close contacting agent, and the adhesive agent elastic modulus (s) is more than 0.00125 less than 55 is preferable because the effect to prevent the breakage of the IC chip can be more expected, and more preferably, it is more than 0.005 less than 10, particularly preferably, more than 0.01 less than 1. In the case where the ratio of the elastic modulus (m) of the close contacting agent, and the adhesive agent elastic modulus (s) is less than 0.00125, when the stress applied to the card surface is distributed stepwise, the effect to absorb the stress applied to the IC chip is decreased. When the ratio is more than 55, the cushion effect by the close contacting agent can not be sufficiently obtained, and the stress applied to the card surface is distributed stepwise, and the effect to absorb the stress applied to the IC chip is decreased.

### <IC Module>

An IC module is one of an information recording member and concretely an IC module comprised of a module supporter, an IC-chip, which electrically records information of an electronic card user, and a coil-shaped antenna element connected thereto. An IC-chip is comprised of only a memory or of a microcomputer in addition thereto. Optionally, an electronic part may also include a condenser. The invention is not limited thereto, and an electronic part is not particularly limited provided that it is necessary for an information recording member.

An IC module is provided with an antenna; in case of being provided with an antenna pattern, it may be prepared by any method such as an electric - conductive paste printing process, a copper foil etching process and a wire welding process. As a printed board, a thermoplastic film such as polyester is utilized, and polyimide is advantageously used in case of high thermal-resistance being required. The bonding of an antenna pattern with an IC-chip is performed by any method commonly known such as a method utilizing electrical-conductive adhesives such as silver paste, copper paste, carbon paste, etc. (for example, EN-4000 Series manufactured by Hitachi Chemical Co., Ltd. and XAP Series manufactured by Toshiba Chemical Corp.); a method utilizing anisotropic electrical-conductive film (such as Anisolm manufactured by Hitachi Chemical Co., Ltd.); and a method applying solder bonding.

In the present invention, a bump formed in a circuitry surface of an IC chip is electrically connected and face a film support on which an antenna is formed. A film support made of a high hard material and a high close contact capability is preferable, because an effect to protect a circuitry surface increases.

To avoid poor stability, such as disconnecting at bonding portions due to shear stress by adhesive flow, and damaging smoothness of the surface due to flow or cooling of an adhesive, caused by filling an adhesive layer resin after a part including an IC-chip is mounted on a predetermined position in advance, a part, to be enclosed in the adhesive layer on a board sheet in advance, is preferably prepared in a form of a porous resin film, a porous foaming resin film, a flexible resin sheet, a porous resin sheet or a non-woven fabric sheet. For example, a method described in Japanese Patent Application No. 11-105476 can be utilized.

For example, a non-woven fabric sheet member includes mesh-form fabric made of non-woven fabric, fabric of plain weave, twilled weave and satin weave. Further, fabric having piles called such as mocket, plushbelour, seal, velvet and suede can be utilized. Materials include fiber of combinations of one or not less than two kinds selected from synthetic resins of a polyamide type such as type 6-nylon, 66-nylon and 8-nylon, a polyester type such as polyethylene terephthalate, a polyolefin type such as polyethylene, polyvinyl alcohol, a polyvinilidene chloride type, a polyvinyl chloride type, an acryl type such as polyacrylonitrile, acrylamide and methacrylamide, a polyvinylidene cyanate type, a polyfluoroethylene type and polyurethane type; natural fibers such as silk, cotton, wool, a cellluose type and a cellulose ester type; regenerated fiber (rayon and actate) and aramide fiber. Among these fabric materials preferable are a polyamide type such as 6-nylon and 66-nylon, an acryl type such as polyacrylnitrile, acrylamide and methacrylamide, a polyester type such as polyethylene terephthalate, a cellulose type as a regenerated fiber, a cellulose ester type such as rayon and acetate and aramide fiber.

The thickness of a module supporting member is preferably from 10 to 50 µm. If it is less than 10 µm, when an obverse side base member and reverse side base member are laminated, there may be caused a problem of heat shrinkage. If it is more than 50 µm, a cushion effect is lowered and an IC chip tends to be broken.

### <Close contacting agent>

The close contacting agent of the present invention permits unrestricted use of commonly employed resin materials the method of the present invention, without departing from the spirit of the invention. To be more specific, it is possible to use the close contacting agent based on epoxy, urethane, silicon, cyanoacrylate, synthetic rubber such as nitrile rubber, ultraviolet cure resin, hot melt resin, anaerobic resin, cellulose and vinyl acetate. These close contacting agent can be used independently or in combination. An elastic epoxy close contacting agent is preferably used. The resin composition formed by combination between epoxy resin and mercaptan based curing agent, disclosed in the Official Gazette of Japanese Patent Tokkaisho 63-63716 has been used as the elastic epoxy close contacting agent to ensure good curability at low temperatures. The epoxy resin composition formed by combination with the complex cyclic diamine curing agent has also been used. The epoxy resin formed by combination with aromatic polyamine curing agent has been used to increase the strength. Further, in order to obtain a high strength, an epoxy resin which includes a combination with an aromatic series polyamine hardener has been used. To improve the working environment characteristics, bondability with the base member member and bonding stability, the epoxy resin composition has been used, which is formed by combination of bisphenol based epoxy resin, and (C) polyamideamine (D) aromatic modified amine and (E) aliphatic modified polyamine, as amine based curing agent, as disclosed in the Official Gazette of Japanese Patent Tokkaihei 10-120764. An epoxy resin, characterized by high curing speed, formed by combination of the epoxy resin and amineimide compound based curing agent is disclosed in the Official Gazette of Japanese Patent Tokkai 2000-229927. The Official Gazettes of Japanese Patents Tokkaihei 6-87190 and 5-295272 show the case of using a special modified silicone prepolymer as a curing agent, and disclose the material characterized by improved flexibility of the resin.

The elastic epoxy close contacting agent that can be used in the present invention includes Cemedine EP-001 by Cemedine Co., Ltd., 3950, 3951 and 3952 of 3950 Series by Threebond Co., Ltd., MOS07 and MOS10 of MOS Series by Konishi Co., Ltd., Urtite 1540 of Urtite 1500 Series by Toho Chemical Industry Co., Ltd., etc.

The film thickness of the close contacting agent is preferably 1 through 100 µm in terms of the value including the thickness of the electronic parts, more preferably, 1 through 70 µm, still more preferably, 3 through 50 µm.

The close contacting agent resin of the present invention preferably has a viscosity of 1000 through 35,000 cps at 23 degrees Celsius, more preferably 3000 through 35000 cps. If the viscosity is below 1,000 cps, the liquid will flow away when the IC chip and reinforcement structural member are brought in close contact with each other. This will cause a film thickness control failure and irregular film thickness. If the viscosity is over 35,000, a coating streak and bubble will be produced at the time of production. This will cause reduce the degree of adhesion.

The resin property of 500 µm of the close contacting agent used in the present invention subsequent to curing is preferably 0.1 through 55 (kg/mm²) at 2% elastic modulus (kg/mm²). If it is less than 0.1 or more than 55 (kg/mm²), the stress and deformation of the IC chip or reinforcement structural member will be concentrated on the IC chip. This will reduce the durability and raises a problem.

The close contacting agent is applied to the reinforcement structural member and IC chip by potting, coating, jetting or printing without particular restriction. If it is applied by potting, it is preferred to increase the number of the potting nozzles. If it is applied by coating, smooth coating is preferred. When the reinforcement structural member is fixed to the IC chip, uniform application of the close contacting agent is preferred. In the present invention, the area of the close contacting agent provided between the curved IC chip and reinforcement structural member is greater than that of the IC chip.

In the present invention, additives can be supplied without departing from the spirit of the invention. Especially, elastic particles are preferably contained in the close contacting agent. The materials that can be added to the close contacting agent include wax, thermosetting resin, inorganic fine particles, leveling agent, rubber elastic particles, thermosetting elastomer, thermosetting resin, pressure sensitive close contacting agent, curing agent, curing catalyst, flow leveling agent, flat particles, needle-shaped particles and others. These substances can be mixed.

Addition of elastic particles is preferred because it reduces the stress applied to the IC chip in the process of fixing the reinforcement structural member, removes the residual strain and improves durability. The stress applied to the IC chip can be reduced and durability can be improved even after a card has been formed.

Such flat substances as mica, talc, laminated silicate and silver halide can be used as flat particles.

The flat silica compound as a flat substance refers to the laminated silicate, namely, flat silicate containing alkali, alkali earth metal, aluminum and others. The examples are karyon mineral, mica clay mineral and smectite. The karyon mineral is exemplified by karyonite, dickite, nakhlite, halloysite and serpentinite. The mica clay mineral includes pyroferrite, talc, muscovite, swelling synthetic fluorine mica, sericite and chlorite. The smectite includes smectite, vermiculite and swelling synthetic fluorine vermiculite. The smectite includes naturally occurring and synthetic ones. The examples of naturally occurring ones are montmorillonite and beidellite. They can be obtained in the form of bentonite and the clay called acid clay. Examples of the synthetic smectite are Lucentite SWN (hereinafter referred to as "STT=1") and Lucentite SWF (2 through 5 wt% of fluorine) (hereinafter referred to as "STT-2) by Corpchemical Co., Ltd.

The preferred amount of the flat particles used in the present invention is 0.10 through 0.90, particularly preferably 0.2 through 0.8, in terms of dry weight ratio, with respect to the binder of the layer where it is to be added.

The examples of needle-shaped particles are hexagonal ferrite such as barium ferrite and strontium ferrite. The needle-shaped particle can be a fabric piece having a high modulus of elasticity such as aramid fiber.

If required, other fine particles can also be used in combination. Other fine particles that can be preferably used are various types of inorganic oxides, carbides, nitrides and borites. They are exemplified by silica, alumina, titania, zirconia, barium titanate, aluminum titanate, strontium titanate, magnesium titanate, calcium titanate, zinc oxide, chromium oxide, cerium oxide, antimony oxide, tungsten oxide, tin oxide, tellurium oxide, manganese oxide, boron oxide, silicon carbide, boron carbide, titanium carbide, silicon nitride, titanium nitride and boron nitride.

The examples of the tackiness polymer include: silicones of a mixture between a silicone rubber such as polydimethyl siloxane and polydiphenyl siloxane; and a silicone resin such as polysiloxane containing the trimethylsilyl group or triphenylsilyl group; polyesters; polyurethanes; polyethers; polycarbonates; polyvinylethers; polyvinyl chlorides; polyvinyl acetates; polyisobutylenes; and other polymer other than acryl-based ones. The examples further include: acryl, acrylonitrylbutadien (NBR), Random type styrene butadiene rubber, butyl rubber, isopyrene rubber (IR), butadiene rubber (BR), ethylenepropylene rubber (EPM), ethylenepropylenedien rubber (EPDM), urethane rubber, styrene isopyrene styrene rubber (SIS), styrene ethylene butadiene styrene block rubber (SEBS) and styrene butadiene block rubber. These substances can be used. The resin having a low thermal softening point, such as acryl polymer mainly made up of alkylacrylate having a low glass-transition temperature, is preferably used to ensure that the polymer as a simple substance will exhibit adequate pressure sensitive bondability.

### <Reinforcement structural member>

In the present invention, a reinforcement structural member is fixed to the IC chip to improve the IC chip durability. The reinforcement structural member of the present invention is preferred to have a high degree of mechanical strength. When the reinforcement structural member thickness is increased to ensure a high degree of mechanical strength, the card thickness will be increased and printability on the surface will deteriorate. Thus, the reinforcement structural member is preferably made of highly rigid materials, such as metal, ceramic, carbon fiber, glass fiber, aramid fiber and highly elastic resin. One of the materials selected from the above or a composite material made of more than one of such selected materials can be used. Especially, the material having a Young's modulus of 100 GPa or more is preferably used as the main material. The thickness is preferably 10 through 300 µm, preferably 30 through 200 µm, more preferably 50 through 150 µm. The reinforcement structural member can be made in any form without departing from the spirit of the invention. In the present invention, it is preferred to use a reinforcement structural member having the curved surface conforming to the curvature of the chip. The reinforcement structural member can be made of a single member, but is more preferably made of a plurality of members because stress distribution on the chip is ensured. When it is made of a plurality of members, lamination of the members characterized by a high degree of mechanical strength is preferred.

### <Method to Provide Electronic Part having Prescribed Thickness between obverse side base member and reverse side base member>

As a manufacturing method to provide a predetermined electronic part between the obverse side base member and the reverse side base member of the invention, a thermal lamination method, an adhesive lamination method and an injection molding method are well known and any of the methods can be utilized. Format printing or information recording may be performed before or after the obverse side base member and the reverse side base member being laminated, and it can be formed by any method such as off-set printing, gravure printing, silk printing, screen printing, intaglio printing, letterpress printing, an ink jet method, a sublimation transfer method, an electrophotographic method and a thermal fusion method.

A manufacturing method of an IC card of the invention is comprised of at least a process in which an adhesive member, being in a state of solid or viscous body at ordinary temperature and softened in a heated state, is provided on a base member for an IC card, a process in which an electronic part is arranged on the base member, a process in which a base member for the obverse surface provided with an adhesive member is arranged so as to cover the electronic part on the base member, and a process in which a base member, an electronic part and a base member for the obverse surface are laminated together; and lamination is preferably performed.

The adhesive member being a solid body or a viscous body and softened in a heated state is preferably prepared by a method in which an adhesive itself is formed in a sheet-form, or by a method in which an adhesive itself is melt by heat or at ordinary temperature and laminated by means of an injection molding method.

Temperature of enabling to adhere an electronic part predetermined between the obverse side base member and the reverse side base member is preferably not higher than 80 °C, more preferably from 0 to 80 °C and furthermore preferably from 20 to 70 °C. A cooling process is preferably provided after the lamination to reduce such as warp of a base member. Cooling temperature is preferably not higher than 70 °C, more preferably from -10 to 70 °C and furthermore preferably from 10 to 60 °C.

At the time of lamination, to enhance smoothness of a base surface and adhesion property of an electronic part predetermined between the obverse side base member and the reverse side base member, they are preferably subjected to heating and pressing, and preferably manufactured by such as an up-and-downward pressing and lamination method. Further, it is preferred to avoid utilizing rolls which provides nearly linear contact and unreasonable bending force with even a slight shift, and to adopt a planer-press type, taking cracking of IC-parts into consideration. The heating is preferably performed at from 10 to 120° C and more preferably from 30 to 100° C. The press is preferably performed at from 0.1 to 300 kgf/cm² and more preferably at from 0.1 to 100 kgf/cm². When the pressure is higher than this, an IC-chip may be collapsed. The time for heating and pressing is preferably from 0.1 to 180 sec. and more preferably from 0.1 to 120 sec.

A laminated sheet or a continuously coated lamination roll, prepared as a continuous sheet by an adhesive-lamination method or a resin injection method described above, may be recorded with certifying identification images and bibliographic items after being allowed to stand for a time equal to a predetermined curing time of an adhesive; thereafter, may be shaped into a prescribed card size. As methods for shaping into a prescribed card size, such as a stamping method and a cutting method are mainly selected.

### <General Description on Image Forming Method of Image Recording Element>

An image recording element of an IC card according to the invention is provided with an image element of at least one selected from a certifying identification image such as a face image, an attribute information image and a format printing is formed on a an image or printing surface side of a substrate.

A face image is generally a full-colored image having tone, and is prepared, for example, by a sublimation thermal transfer recording method or a silver halide color photographic method. A letter information image, comprises a binary image, and is formed, for example, by such as a fusion thermal transfer recording method, a sublimation thermal transfer recording method, a silver halide color photographic method, electrophotographic method, or an ink-jet method.

In the invention, it is preferable to record a certifying identification image such as a face image and an attribute information image by a sublimation thermal transfer recording method. Attribute information include a name, an address, a birth date, a license, etc., and are recorded, usually as letter information, generally by means of a fusion thermal transfer recording method. A format printing or information recording may also be performed, and this can be formed by any method such as offset printing, gravure printing, silk printing, screen printing, intaglio printing, letterpress printing, an ink-jet method, a sublimation transfer method, an electrophotographic method and a thermal fusion method.

Further, for the purpose of preventing forgery and alternation, an optical variable device described below such as a hologram and a fine structure tint may be adopted. A layer to prevent forgery and alternation is optionally selected from a printed matter, a hologram, a bar cord, a matte pattern, a fine structure tint, a ground tint and a roughened pattern, and is comprised of a visible light absorbing colorant, a UV absorbent, an infrared absorbent, a fluorescent brightener, a metal evaporated layer, a glass evaporated layer, a bead layer, an optical variable element layer, a pearl ink layer and a scaly pigment layer.

### [Sublimation image forming method]

An ink sheet for sublimation thermal transfer recording of a sublimation image forming method can be composed of a base member and an ink layer formed thereon containing sublimation dyes.

### -Base member-

As a base member, there is no specific limitation, and those well known in the art, provided being superior in dimensional stability and resistant against heat at the time of recording with a thermal head, can be utilized.

### -Sublimation Dye Containing Ink Layer-

The sublimation dye containing ink layer described above basically contains a sublimation dye and a binder.

The above-described sublimation dye includes cyan dyes, magenta dyes and yellow dyes.

The cyan dyes include naphthoquinone type dyes, anthraquinone type dyes and azomethine type dyes described in such as JP-A Nos. 59-78896, 59-227948, 60-24966, 60-53563, 60-130735, 60-131292, 60-239289, 61-19396, 61-22993, 61-31292, 61-31467, 61-35994, 61-49893, 61-148269, 62-191191, 63-91288, 63-91287 and 63-290793.

The magenta dyes include anthraquinone type dyes, azo type dyes and azomethine type dyes described in such as JP-A Nos. 59-78896, 60-30392, 60-30394, 60-253595, 61-262190, 63-5992, 63-205288, 64-159 and 64-63194.

The yellow dyes include methine type dyes, azo type dyes, quinophthalone type dyes and anthraisothiazole type dyes described in such as JP-A Nos. 59-78896, 60-27594, 60-31560, 60-53565, 61-12394 and 63-122594.

Specifically preferable sublimation dyes are azomethine dyes obtained by coupling reaction of compounds having a closed-chain type or open-chain type active methylene group, with oxidants of p-phenylenediamine derivatives or those of p-aminophenol derivatives; and indoaniline dyes obtained by coupling reaction of phenol or naphthol derivatives with oxidants of p-phenylenediamine derivatives or those of p-aminophenol derivatives.

Further, when a metal ion containing compound is included in an image receiving layer, it is preferable to include a sublimation dye that forms a chelate upon reaction with the metal ion containing compound, in a sublimation dye including ink layer. Examples of the chelate forming sublimation dyes include cyan dyes, magenta dyes and yellow dyes, forming a chelate of at least bidentate, described in JP-A Nos. 59-78893 and 59-109349, Japanese Patent Application Nos. 2-213303, 2-214719 and 2-203742.

Preferable sublimation dyes capable of forming a chelate can be represented by the following general formula:

X₁-N=N-X₂-G

where, X₁ represents an aromatic carbon ring, in which at least one ring is composed of 5 to 7 atoms, or an atomic group necessary to complete a heterocyclic ring, provided that at least one of the adjacent positions to carbon atoms which bond to the azo bond is a carbon atom substituted by a nitrogen atom or a chelating group; X₂ represents an heterocyclic ring, in which at least one ring is composed of 5 to 7 atoms, or an aromatic carbon ring; and G represents a chelating group.

Any sublimation dyes contained in the sublimation dye containing ink layer above described, may be any of a yellow dye, a magenta dye and a cyan dye when an image to be formed is monocolor, and any two or more dyes out of three dyes above described or other sublimation dyes may be contained depending on the color of an image to be formed. The using amount of sublimation dyes described above generally from 0.1 to 20 g and preferably 0.2 to 5 g, based on 1 m² of a base member.

A binder for an ink layer is not specifically limited, and those well known in the art can be used.

Further, in the aforementioned ink layer, various kinds of additives well known in the art can be suitably added. An ink sheet for sublimation thermal transfer recording can be prepared in such a manner that ink layer coating solution, which has been prepared by dispersing or solving various ink layer components described above, is coated on a base member and then dried. The thickness of thus prepared ink layer is generally from 0.2 to 10 µm and preferably from 0.3 to 3 µm.

### EXAMPLES

The invention will be described below, based on examples, however the embodiment of the invention is not limited thereto. Hereinafter, "part(s)" represents "part(s) by weight".

### <Preparation of Adhesive>

### Adhesive

Macroplast QR3460 (2% elastic-modulus 15kg/mm2, moisture-curable adhesive), manufactured by Henkel Co. was used.

### [Production of IC module]

### (Close contacting agent)

### Close contacting agent 1

Two liquid hardening type elastic epoxy adhesive: manufactured by Toho Chemical Industry limited company

Main agent using Ultait 1540 set (after-hardening, 2% elastic-modulus: 0.4 kg/mm²) and a hardener were used. Close contacting agent 2
- Two liquid hardening type elastic epoxy adhesive: manufactured by Toho Chemical Industry limited company Ultait 1540 set 90 parts
- Silicone resin powder (Tosspearl 150; made by GE Toshiba Silicones Co., Ltd.) 10 parts

The above-mentioned compositions were stirred with a homogenizer for 60 minutes, thereby Adhesive 3 was produced. A hardener was added right before use.

### (2% elastic-modulus: 1 kg/mm²)

### Close contacting agent 3

Main agent using Threebond main agent 2002H / hardener 2105F (after-hardening, 2% elastic-modulus: 0.05 kg/mm²) and a hardener were used.

### Close contacting agent 4

Aronalpha GEL-10 (2% module of elasticity is 60 kg/mm², manufactured by Toagosei Co., Ltd.) was used.

### Close contacting agent 4

Semicoat 220H (2% elastic-modulus: 300kg/mm², manufactured by Shin-Etsu Chemical Co., Ltd.) was used.

IC module 1: shown in Figs. 1 to 3.

An IC-chip of 65 µm thick and 3 x 3 mm square was adhered by use of an electro-conductive adhesive of 20 µm thick on a transparent PET support having a thickness of 38 µm on which an antenna pattern had been formed by etching, and a first reinforcement plate of 50 µm thick and 4 x 4 mm square comprised of SUS 301 was adhered with pressure on the opposite side to a circuit surface by potting Close contacting agent resin 1 to be 10 µm thick so as to seal the chip.

Then, a second reinforcement plate of 50 µm thick and 5 x 5 mm square comprised of SUS 301 was adhered with pressure on the first reinforcement plate by potting Close contacting agent resin 1 to become 10 µm thick with an area larger than that of the second reinforcement plate so as to seal the chip, thereby IC module 1 was prepared. The largest thickness of an IC chip portion was 262 µm.

IC module 2: shown in Fig. 4(a).

IC module 2 was prepared with the same manner of IC module 1 except that Close contacting agent resin 1 was made close contact to an extent not to seal the chip.

IC module 3: shown in Figs. 1 to 3.

IC module 3 was prepared with the same manner of IC module 1 except that a 25 µm PEN (polyethylenenaphthalate) film was used as the film support, IC chip was made 180 µm and the thickness of the reinforcement plate was made to be 30 µm respectively. The largest thickness of an IC chip portion was 327 µm.

IC module 4: shown in Figs. 1 to 3.

IC module 4 was prepared with the same manner of IC module 1 except that a 10 µm polyimide film was used as the film support and IC chip was made 120 µm. The largest thickness of an IC chip portion was 292 µm.

IC module 5: shown in Figs. 5 and 6.

IC module 5 was prepared with the same manner of IC module 1 except that the first and second reinforcement plates was made to be a disk of 5 mm diameter and IC chip was made 120 µm. The largest thickness of an IC chip portion was 320 µm.

IC module 6: shown in Fig. 7.

IC module 5 was prepared with the same manner of IC module 1 except that the first reinforcement plate was made to be a disk of 4 mm diameter, IC chip was made 120 µm and Close contacting agent resin 2 was used. The largest thickness of an IC chip portion was 320 µm.

IC module 7: shown in Figs. 1 to 3.

IC module 7 was prepared with the same manner of IC module 6 except that Close contacting agent resin 3 was used. The largest thickness of an IC chip portion was 320 µm.

IC module 8: shown in Figs. 1 to 3.

IC module 8 was prepared with the same manner of IC module 6 except that Close contacting agent resin 4 was used. The largest thickness of an IC chip portion was 320 µm.

IC module 9: shown in Figs. 1 to 3.

IC module 9 was prepared with the same manner of IC module 1 except that the thickness of IC chip was made 200 µm and the thickness of the reinforcement plate was made to be 30 µm respectively. The largest thickness of an IC chip portion was 360 µm.

IC module 10: shown in Figs. 1 to 3.

IC module 10 was prepared with the same manner of IC module 1 except that the thickness of the close contacting agent was made 55 µm respectively and the thickness of the reinforcement plate was made to be 30 µm respectively. The largest thickness of an IC chip portion was 310 µm.

IC module 11: shown in Figs. 1 to 3.

IC module 11 was prepared with the same manner of IC module 1 except that the thickness of the film support was made 75 µm and the thickness of the reinforcement plate was made to be 30 µm respectively. The largest thickness of an IC chip portion was 257 µm.

IC module 12: shown in Figs. 1 to 3.

IC module 12 was prepared with the same manner of IC module 2 except that the second reinforcement plate was made to be 3 x 3 mm square. The largest thickness of an IC chip portion was 260 µm.

IC module 13: shown in Figs. 8 and 9.

IC module 13 was prepared with the same manner of IC module 1 except that the thickness of IC chip was made 25 µm. The largest thickness of an IC chip portion was 225 µm.

IC module 14: shown in Fig. 10.

IC module 14 was prepared with the same manner of IC module 1 except that the second reinforcement plate was not provided. The largest thickness of an IC chip portion was 270 µm.

IC module 15: shown in Fig. 11.

To a transparent PET base member of the thickness 38 µm in which an antenna pattern is formed by etching, the IC chip of the thickness 120 µm, 3 × 3 mm square is joined by the conductive adhesive agent of the thickness 20 µm, and the first reinforcing plate which is formed of SUS 301 and the thickness 50 µm and 4 × 4 mm square plate, is potted and pressure-adhered to the opposite side to the circuit surface in such a manner that the chip is sealed and the thickness of the close contacting agent resin 1 becomes 10 µm.

Next, to the opposite side to the IC chip of the transparent PET base member to which the chip is joined, the second reinforcing plate which is formed of SUS 301 and the thickness 50 µm, 4 × 4 mm square plate is potted so that it is larger than the second reinforcing plate area and the thickness is 10 µm, by the close contacting agent resin 1, and pressure-adhered, and the IC module 15 is obtained.

The maximum thickness of the IC chip part is 320 µm.

The IC module 16 is shown in Fig. 12 and Fig. 13.

To a transparent PET base member of the thickness 250 µm in which an antenna pattern is formed by etching, the opposite side to the circuit surface of the IC chip of the thickness 180 µm, 3 × 3 mm square is potted on the lead frame metal plate of thickness 110 µm, 4 × 5 mm square plate so that the thickness of the close contacting agent resin is 5 µm, and the chip is closely adhered, and after the circuit and the lead frame are electrically connected by wire bonding, the close contacting agent resin 5 is further potted so as to seal on the IC chip in the thickness of 80 µm, and the IC chip is sealed. Next, with a transparent PET in which an antenna is formed, the chip sealing part is engaged, the lead frame and the antenna are electrically connected to each other by the conductive adhesive agent, and the IC module 16 is obtained. The maximum thickness of the IC chip part is 370 µm.

The IC module 17 is shown in Fig. 14 and Fig. 15.

A bump of the IC chip of the thickness 180 µm, 3 × 3 mm square is electrically connected directly to a copper wire antenna of 50 µm φ, and the first reinforcing plate which is formed of SUS 301, and thickness 30 µm, 4 × 4 mm square plate is potted to the opposite side to the circuit surface so that the thickness of the close contacting agent rein 1 is 10 µm, and the chip is pressure-adhered. Next, the second reinforcing plate which is formed of SUS 301, and thickness 30 µm, 5 × 5 mm square plate is potted on the first reinforcing plate by the close contacting agent resin 1 so that the thickness of the close contacting agent rein 1 is 10 µm, and the chip is pressure-adhered. Next, on the non-woven cloth base member of 50 µm thickness, the reinforcing plate and the antenna are closely contacted, and the IC module 17 is obtained. The maximum thickness of the IC chip part is 370 µm.

### <Example 1>

### [Production of IC card]

Table 1 shows Example.

Figs. 1 to 3 show an example of a lamination layer structure of an IC card and a personal authentication card according to the invention.

### Base member 1;

As a obverse side base member and a reverse side base member, a white PET sheet having a thickness of 188 µm was used.

### <Preparation of obverse surface base member>

### <Base member 1>

The first image receiving layer coating solution, the second image receiving layer coating solution and the third image receiving layer coating solution, having the compositions described below, were coated and then dried, in this order, on a corona discharge treated surface of a 188 µm obverse surface base member to be accumulated so as to make each thickness of 0.2 µm, 2.5 µm and 0.5 µm. Thus an image receiving layer was formed.

### <First Image Receiving Layer Coating Solution>

| | |
|---|---|
| Polyvinyl butylal resin (Eslec BL-1, manufactured by Sekisui Chemical Co., Ltd.) | 9 parts |
| Isocyanate (Coronate HX, manufactured byNippon Polyurethane Kogyo Co., Ltd.) | 1 part |
| Methyl ethyl ketone | 80 parts |
| Butyl acetate | 10 parts |

### <Second Image Receiving Layer Coating Solution>

| | |
|---|---|
| Polyvinyl butyral resin (Eslec BX-1, manufactured by Sekisui Chemical Co., Ltd.) | 6 parts |
| Metal ion containing compound (Compound MS) | 4 part |
| Methyl ethyl ketone | 80 parts |
| Butyl acetate | 10 parts |

### <Third Image Receiving Layer Coating Solution>

| | |
|---|---|
| Polyethylene wax (Hitech E1000, manufactured by Toho Chemical Industry Co., Ltd.) | 2 parts |
| Urethane modified ethylene acrylic acid copolymer (Hitech S6254, manufactured by Toho Chemical Industry Co., Ltd.) | 8 parts |
| Methyl cellulose (SM15, manufactured by Shin-Etsu Chemical Co., Ltd.) | 0.1 part |
| Water | 90 parts |

### <Format Printing>

A logogram and OP varnish were printed successively by a resin letterpress method.

### <Preparation of reverse surface base member>

### <Preparation of Writing Layer>

The first writing layer coating solution, the second writing layer coating solution and the third writing layer coating solution, having the compositions described below, were coated and then dried, in this order, on a corona discharge treated surface of the 188 µm reverse surface sheet of the base member described above to be accumulated so as to make each thickness of 2 µm, 10 µm and 0.2 µm. Thus a writing layer was formed.

### <First Writing Layer Coating Solution>

| | |
|---|---|
| Polyester resin (Vilon 200, manufactured by Toyobo Co., Ltd.) | 8 parts |
| Isocyanate (Coronate HX, manufactured by Nippon Polyurethane Kogy Co., Ltd.) | 1 part |
| Carbon black | a slight amount |
| Titanium dioxide particles (CR80, manufacturedby Ishihara Sangyo Kaisha Ltd.) | 1 part |
| Methyl ethyl ketone | 80 parts |
| Butyl acetate | 10 parts |

### <Second Writing Layer Coating Solution>

| | |
|---|---|
| Polyester resin (Vilonal MD1200, manufactured by Toyobo Co., Ltd.) | 4 parts |
| Silica | 5 parts |
| Titanium dioxide particles (CR80, manufacturedby Ishihara Sangyo Kaisha Ltd.) | 1 part |
| Water | 90 parts |

### <Third Writing Layer Coating Solution>

| | |
|---|---|
| Polyamide resin (Sunmide 55, manufactured by Sanwa Chemical Ind. Co., Ltd.) | 5 parts |
| Methanol | 95 parts |

A center line mean roughness of the writing layer obtained was 1.34 µm.

### <Preparation of Sheet for IC card>

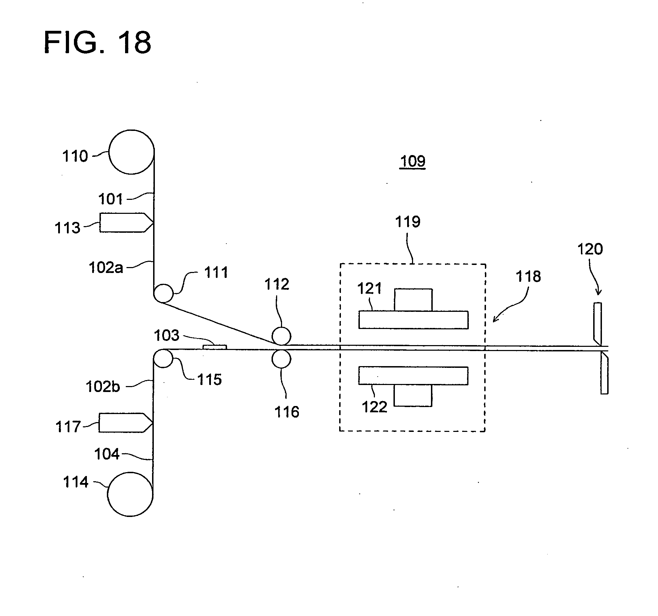

Fig. 18 shows an example of a producing apparatus of an IC card according to the invention. IC card producing apparatus 109 is equipped with a sending-out axis 110 which sends out first sheet member 101, and first sheet member 101 being sent out from sending-out axis 110 is fed being hanged through guide roller 111 and drive roller 112. Applicator coater 113 is arranged between sending-out axis 110 and guide roller 111. Applicator coater 113 coats adhesive 102a on a sheet at a predetermined thickness.

Further, IC card producing apparatus 100 is equipped with sending-out axis 114 which sends out the first sheet member 104, and the first sheet member 104 being sent out from sending-out axis 114 is fed being hanged through guide roller 115 and drive roller 116. Applicator coater 117 is arranged between sending-out axis 114 and guide roller 115. Applicator coater 117 coats adhesive 102b on a sheet at a prescribed thickness.

First sheet member 101 and first sheet member 104, on which an adhesive having been coated, are brought in contact to be transported along transporting passage 118 from the state of facing to each other while being separated. IC module 103 is inserted at the position where first sheet member 101 and first sheet member 104 are facing to each other while being separated. IC module 103 is fed as an unite, or as plural units in a sheet-form or a roll-form. In transport passage 118 of IC card producing apparatus 100, heat laminator section 119 and cutting section 120 are arranged along a transport direction of first sheet member 101 and first sheet member 104. A heat laminator is preferably a vacuum heat laminator. Further, protective film supply sections may be provided before heat laminator section 119 and are preferably arranged over and under transport passage 118 facing to each other. Heat laminator section 119 is constituted of heat laminator over-type 121 and heat laminator under-type 122 arranged over and under transport passage 118 facing to each other. Heat laminator over-type 121 and heat laminator under-type 122 are set to be shiftable in a direction of contacting with and separating from each other. The sheet material is cut into a prescribed size after passing through heat laminator section 119.

### <Preparation of Sheet 1 for IC card>

A card producing apparatus of Fig. 18 was utilized and the above-described reverse side base member and the obverse side base member having an image receiving layer produced by using <Base member 1> were utilized as a reverse side base member and an obverse side base member.

Adhesive 1 was coated on the obverse surface base member having an image receiving layer by use of T dies so as to make a thickness of 40 µm; adhesive 1 was coated with thickness adjustment on the reverse surface base member by use of T dies so as to make the total thickness of sheet to be 760 µm after lamination, and C module 1 was mounted on the obverse side base member such that the image receiving layer side became a support side on which an IC chip of the IC module was not installed and then sandwiched by to and bottom sheets; and the resulting configuration was laminated for 1 minute at 70 °C to prepare an IC card sheet. Thus produced sheet for an IC card has a thickness of 760 µm. The sheet after preparation was kept for 7 days under an environment of 25 °C and 50% RH.

### [Punching]

A sheet for an IC card thus prepared was subjected to a stamping process by use of the following IC card stamping dies apparatus.

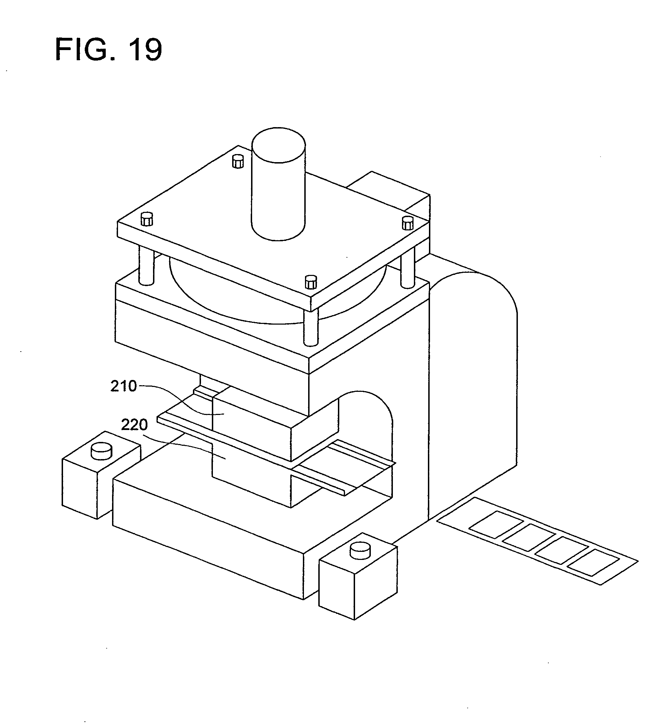

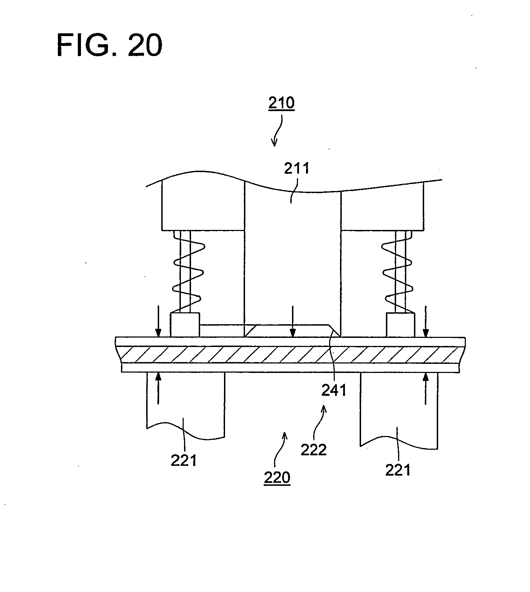

Fig. 19 is a brief oblique view drawing of a stamping dies apparatus and Fig. 20 is a front end view drawing of a main portion of a stamping dies apparatus. The stamping dies apparatus provided with a stamping dies having over blade 210 and under blade 220. Herein, over blade 210 includes stamping punch 211 provided with escape 241 at the inside of an outer edge and under blade 220 has stamping dies hole 222. An IC card having the same size as that of dies hole 222 is stamped by descending stamping punch 211 into dies hole provided at the center of stamping dies 221. Further, for this purpose, the size of stamping punch 211 is slightly smaller than the size of stamping dies hole 222.

### <Information Recording Method on Personal Certification Card and Surface Protection Method>

A face image, attribute information and a format printing were provided according to the following manner on the above-described IC card having been subjected to a stamping process to prepare a personal certification card.

### <Preparation of Ink Sheet for Sublimation Thermal Transfer Recording>

Ink sheets of three colors of yellow, magenta and cyan were obtained by providing a yellow ink layer coating solution, a magenta ink layer coating solution and a cyan ink layer coating solution of the following compositions on a polyethylene terephthalate sheet of 6 µm thick, the back-side thereof being subjected to anti-melt-adhesion treatment, so as to make each thickness of 1 µm.

### <Yellow Ink Layer Coating Solution>

| | |
|---|---|
| Yellow dye (Compound Y-1) | 3 parts |
| Polyvinylacetal | 5.5 parts |
| (Product of Denki-Kagaku Ind. Co., Ltd.: Denkabutyral KY-24) | |
| Polymethyl methacrylate modified polystyrene | 1 part |
| (Product of Toa-Goseikagaku Ind. Co., Ltd.: Lededa GP-200) | |
| Urethane modified silicone oil | 0.5 parts |
| (Product of Dainichi-Seika Ind. Co., Ltd.: Diaromer SP-2105) | |
| Methyl ethyl ketone | 70 parts |
| Toluene | 20 parts |

### <Magenta Ink Layer Coating Solution>

| | |
|---|---|
| Magenta dye (Compound M-1) | 2 parts |
| Polyvinylacetal | 5.5 parts |
| (Product of Denki-Kagaku Ind. Co., Ltd.: Denkabutyral KY-24) | |
| Polymethyl methacrylate modified polystyrene | 2 parts |
| (Product of Toa-Goseikagaku Ind. Co., Ltd.: Lededa GP-200) | |
| Urethane modified silicone oil | 0.5 parts |
| (Product of Dainichi-Seika Ind. Co., Ltd.: Diaromer SP-2105) | |
| Methyl ethyl ketone | 70 parts |
| Toluene | 20 parts |

### <Cyan Ink Layer Coating Solution>

| | |
|---|---|
| Cyan dye (Compound C-1) | 1.5 parts |
| Cyan dye (Compound C-2) | 1.5 parts |
| Polyvinylacetal | 5.6 parts |
| (Product of Denki-Kagaku Ind. Co., Ltd.: Denkabutyral KY-24) | |
| Polymethyl methacrylate modified polystyrene | 1 part |
| (Product of Toa-Goseikagaku Ind. Co., Ltd.: Lededa GP-200) | |
| Urethane modified silicone oil | 0.5 parts |
| (Product of Dainichi-Seika Ind. Co. Ltd.: Diaromer SP-2105) | |
| Methyl ethyl ketone | 70 parts |
| Toluene | 20 parts |

### <Preparation of Ink Sheets for Fusion Thermal Transfer Recording>

An ink sheet was obtained by coating and drying an ink layer coating solutions of the following compositions so as to make a thickness of 2 µm on a polyethylene terephthalate sheet of 6 µm thick, the back-side thereof being subjected to anti-melt-adhesion treatment.

### <Ink Layer Coating Solution>

| | |
|---|---|
| Carnauba wax | 1 part |
| Ethylene vinylacetate copolymer | 1 part |
| (Product of Mitsui Dupont Chemicals Co.: EV40Y) | |
| Carbon black | 3 parts |
| Phenol resin | 5 parts |
| (Product of Arakawa-Kagaku Ind. Co., Ltd.: Tamanol521) | |
| Methyl ethyl ketone | 90 parts |

### <Formation of Face Image>

A personal image having tone was formed on the image receiving layer by overlapping an image receiving layer and an ink-side of an ink sheet for sublimation thermal transfer recording, and heating from the ink sheet side by use of a thermal head under conditions of an output power of 0.23 W/dot, a pulse width of from 0.3 to 4.5 m·sec and a dot density of 16 dot/mm. In the image, dyes described above and nickel in the image receiving layer formed complexes.

### <Formation of Letter Information>

Letter information was formed on OP vanish by overlapping an OP vanish portion and an ink side of an ink sheet for fusion-type thermal transfer recording and heating from the ink sheet side by use of a thermal head under conditions of an output power of 0.5 W/dot, a pulse width of 1.0 m·sec and a dot density of 16 dot/mm.

### <Surface Protecting Method>

### <Preparation of Surface Protective Layer>

### <Preparation of Actinic-ray Curable Transfer Foil 1>

The following compositions were accumulated on a peeling layer of polyethylene terephthalate film 2 of 25 µm thick, on which a peeling layer comprised of fluorine resin layer of 0.1 µm had been provided, to prepare actinic-ray curable transfer foil 1.

### <Actinic-ray Curable Compound>

| | |
|---|---|
| Product of Shin-Nakamura Kagaku Co., Ltd.: A-9300 / Product of Shin-Nakamura Kagaku Co., Ltd.: EA-1020 = 35 / 1.75 parts | |
| Reaction initiator: Irgacure 184, manufactured by Ciba Geigie Co. | 5 parts |
| Additive: unsaturated group containing resin | 48 parts |
| Other additive: Surfactant F-179, manufacturedby Dainippon Ink & Cemicals Inc. | 0.25 parts |

### <Intermediate Layer Coating Solution>

| | |
|---|---|
| Layer thickness: | 1.0 µm |
| Polyvinyl butyral resin (Product of Sekisui Chemicals Co., Ltd., Eslec BX-1) | 3.5 parts |
| Taftex M-1913 (Asahi Chemical Industry Co., Ltd.) | 5 parts |
| Hardener: Polyisocyanate (Coronate HX,manufactured by Nippon Polyurethane Co., Ltd.) | 1.5 parets |
| Methyl ethyl ketone | 90 parts |

Curing after coating of a hardener was performed at 50 °C for 24 hours.

### <Adhesive Layer Coating Solution>

| | |
|---|---|
| Layer thickness: | 0.5 µm |
| Urethane modified ethylene-ethylacrylate copolymer (Product of Toho Kagakukogyo Co., Ltd.: Hitech S6254B) | 8 parts |
| Polyacrylic acid ester copolymer (Product of Nippon Junyaku Co., Ltd.: Julimer AT510) | 2 parts |
| Water | 45 parts |
| Ethanol | |

Further, a protective layer was transferred on the above-described image receiving layer on which images and letters were recorded, by utilizing actinic-ray curable transfer foil 1 comprised of the foregoing composition and by use of a heat roller of 5 cm diameter having a rubber hardness of 85 and being heated at a surface temperature of 200 °C and a pressure of 150 kg/cm² in 1.2 sec. The card prepared had a thickness of 760 µm and a rebound coefficient of a card was measured to be 0.61.

### <Example 2>

Example 2 was conducted with the same manner of Example 1 except that Module 2 was used.

### <Example 3>

Example 3 was conducted with the same manner of Example 1 except that Module 3 was used.

### <Example 4>

Example 4 was conducted with the same manner of Example 1 except that Module 3 was used, a support surface on which an IC chip of the IC module was not installed was mounted at the writing layer side, a writing layer side adhesive layer thickness was made 40 µm and an image receiving layer side adhesive layer thickness was adjusted such that the total thickness became 760 µm.

### <Example 5>

Example 5 was conducted with the same manner of Example 1 except that Module 4 was used.

### <Example 6>

Example 6 was conducted with the same manner of Example 1 except that Module 5 was used.

### <Example 7>

Example 7 was conducted with the same manner of Example 1 except that Module 6 was used.

### <Example 8>

Example 8 was conducted with the same manner of Example 1 except that Module 7 was used.

### <Example 9>

Example 9 was conducted with the same manner of Example 1 except that Module 8 was used.

### <Example 10>

Example 10 was conducted with the same manner of Example 1 except that Module 9 was used.

### <Example 11>

Example 11 was conducted with the same manner of Example 1 except that Module 10 was used.

### <Example 12>

Example 12 was conducted with the same manner of Example 1 except that Module 11 was used.

### <Example 13>

Example 13 was conducted with the same manner of Example 1 except that Module 12 was used.

### <Example 14>

Example 14 was conducted with the same manner of Example 1 except that Module 13 was used.

### <Comparative Example 1>

Comparative Example 1 was conducted with the same manner of Example 1 except that Module 14 was used.

### <Comparative Example 2>

Comparative Example 2 was conducted with the same manner of Example 1 except that Module 15 was used.

### <Comparative Example 3>

Comparative Example 3 was conducted with the same manner of Example 1 except that Module 16 was used.

### <Comparative Example 4>

Comparative Example 3 was conducted with the same manner of Example 1 except that Module 17 was used.

### <Evaluation>

### <Repeated Bending Test>

Repeated bending of 100 times was performed, being clamped on a chip, at an amplitude of 50 mm, a gap of 30 mm and 120 times/min, by use of a crumple tester of JIS K6404-6. An operability, and modification, and breakage were confirmed after the test.

A: No change was observed without modification and peeling. An operability was not changed.

B: Although there was not problem without modification and peeling, a trace remained. An operability was not changed.

C: Although there was no peeling and breakage, there was modification. A part of them was not operable.

D: There was modification, peeling and breakage. All numbers were not operable.

### <Test of Strength against Point Pressure>

A load of 1 kg with a steel ball having a top edge diameter of 1 mm was applied 200 times to each of a circuit plane and a non-circuit plane of an IC-chip, placed on a rubber sheet having a hardness of 50. An operability, and modification, and breakage were confirmed after the test.

A: No change was observed without modification and peeling. An operability was not changed.

B: Although there was not problem without modification and peeling, a trace remained. An operability was not changed.

C: Although there was no peeling and breakage, there was modification. A part of them was not operable.

D: There was modification, peeling and breakage. All numbers were not operable.

### <Impact Test>

By use of a dropping body type impact tester of JIS K5600·5-3, a card was rigidly fixed on a receiving table having a hole of 27 mm inner diameter by being sandwiched from upside and downside so that an IC-chip was positioned at the center, and a weight having a top edge diameter of 20 mm and a weight of 100 gf (S45C steel) was free dropped from a height of 10 cm on an IC-chip at the center of the receiving table. Movement, deformations and breaks were confirmed after the test.

A: No change was observed without modification and peeling. An operability was not changed.

B: Although there was not problem without modification and peeling, a trace remained. An operability was not changed.

C: Although there was no peeling and breakage, there was modification. A part of them was not operable.

D: There was modification, peeling and breakage. All numbers were not operable.

### <Printing Ability (Roughness Property)>

A sublimation image was printed on a card prepared and degree of scratchiness was evaluated.

B: Printable without problems,

C: There is a portion of decreased density,

D: There is a portion of complete color missing.

The results are shown in Tables 1 and 2.

**Table 1**

| | Module | CCA | *2 | Chip size mm | First R.P. size mm | Second R.P. size mm | CCA size | *5 | *6 | Chip thick µm | CCA thick µm | *7 | *8 | *9 | IC Chip thick µm |
|---|---|---|---|---|---|---|---|---|---|---|---|---|---|---|---|
| Exam.1 | modu.1 | CCA1 | PET | 3×3mm | 4×4mm | 5×5mm | *1 | 0.4 | S/S | 60 | 10 | 38 | 50 | 50 | 260 |
| Exam.2 | modu.2 | CCA1 | PET | 3x3mm | 4x4mm | 5×5mm | *4 | 0.4 | S/S | 60 | 10 | 38 | 50 | 50 | 260 |
| Exam.3 | modu.3 | CCA1 | PEN | 3×3mm | 4×4mm | 5×5mm | *1 | 0.4 | S/S | 180 | 10 | 25 | 30 | 30 | 327 |
| Exam.4 | modu.3 | CCA1 | PEN | 3×3mm | 4×4mm | 5×5mm | *1 | 0.4 | S/S | 180 | 10 | 25 | 30 | 30 | 327 |
| Exam.5 | modu.4 | CCA1 | PI | 3×3mm | 4×4mm | 5×5mm | *1 | 0.4 | S/S | 120 | 10 | 10 | 50 | 50 | 292 |
| Exam.6 | modu.5 | CCA1 | PET | 3×3mm | 5mmφ | 5mmφ | *1 | 0.4 | C/C | 120 | 10 | 38 | 50 | 50 | 320 |
| Exam.7 | modu.6 | CCA2 | PET | 3×3mm | 4mmφ | 5×5mm | *1 | 1 | C/S | 120 | 10 | 38 | 50 | 50 | 320 |
| Exam.9 | modu.7 | CCA3 | PET | 3x3mm | 4mmφ | 5×5mm | *1 | 0.05 | C/S | 120 | 10 | 38 | 50 | 50 | 320 |
| Exam.8 | modu.8 | CCA4 | PET | 3x3mm | 4mmφ | 5×5mm | *1 | 60 | C/S | 120 | 10 | 38 | 50 | 50 | 320 |
| Exam.10 | modu.9 | CCA1 | PET | 3x3mm | 4x4mm | 5×5mm | *1 | 0.4 | S/S | 200 | 10 | 38 | 30 | 30 | 360 |
| Exam. 11 | modu.10 | CCA1 | PET | 3x3mm | 4x4mm | 5×5mm | *1 | 0.4 | S/S | 60 | 55 | 38 | 30 | 30 | 310 |
| Exam.12 | modu.11 | CCA1 | PET | 3x3mm | 4x4mm | 5×5mm | *1 | 0.4 | S/S | 60 | 10 | 75 | 30 | 30 | 257 |
| Exam.13 | modu.12 | CCA1 | PET | 3x3mm | 4x4mm | 3×3mm | *4 | 0.4 | S/S | 60 | 10 | 38 | 50 | 50 | 260 |
| Exam.14 | modu.13 | CCA1 | PET | 3x3mm | 4x4mm | 5×5mm | *1 | 0.4 | S/S | 25 | 10 | 38 | 50 | 50 | 225 |
| Comp.1 | modu.14 | CCA1 | PET | 3x3mm | 4x4mm | No | *1 | 60 | | 120 | 10 | 38 | 50 | 0 | 270 |
| Comp.2 | modu.15 | CCA1 | PET | 3x3mm | 4x4mm | 4x4mm *3 | *1 | 60 | S/No | 120 | 10 | 38 | 50 | 50 | 320 |
| Comp.3 | modu.16 | CCA5 | PET-G | 3x3mm | 4x4mm | No | *1 | 300 | S/S | 180 | 10 | 250100 | | No | 370 |
| Comp.4 | modu.17 | CCA1 | Fabric | 3x3mm | 4x4mm | 5×5mm | *1 | 60 | S/No | 180 | 10 | 50 | 30 | 30 | 370 |

| | | | | | | | | | | | | | | | |
|---|---|---|---|---|---|---|---|---|---|---|---|---|---|---|---|
| Exam.: Example, Comp.: Comparative example, CCP: Close contact agent, R.P.: Reinforcement plate, *1: Lager than a reinforcement plate and sealed, S/S: Square/square, C/C: Circle/circle, C/S: Circle/square, *2: Antenna Film Support, *3: opposite side, *4: No seal, *5: CCA Elastic-modulus kg/mm² *6: R.P. shape First/Second, *7: Film support thick µm, *8: First R.P. thick µm, *9: Second R.P. thick µm | | | | | | | | | | | | | | | |

**Table 2**

| | Module | CCA | Result | | | |
|---|---|---|---|---|---|---|
| | | | Repet. bend test | Point Press test | Impact test | Print |
| Examp. 1 | Module1 | CCA1 | A | A | A | A |
| Examp.2 | Module2 | CCA1 | A | A | A | B |
| Examp.3 | Module3 | CCA1 | B | A | B | B |
| Examp.4 | Module3 | CCA1 | B | A | B | C |
| Examp.5 | Module4 | CCA1 | B | A | A | A |
| Examp.6 | Module5 | CCA1 | B | A | B | A |
| Examp.7 | Module6 | CCA2 | A | A | A | A |
| Examp.9 | Module7 | CCA3 | A | B | A | A |
| Examp.8 | Module8 | CCA4 | A | A | B | A |
| Examp.10 | Module9 | CCA1 | B | A | B | C |
| Examp.11 | Module10 | CCA1 | A | B | B | A |
| Examp.12 | Module11 | CCA1 | B | A | A | A |
| Examp.13 | Module12 | CCA1 | B | A | B | B |
| Examp.14 | Module13 | CCA1 | A | C | A | A |
| Comp.1 | Module14 | CCA1 | D | D | D | B |
| Comp.2 | Module15 | CCA1 | C | C | C | D |
| Comp.3 | Module16 | CCA5 | D | B | D | D |
| Comp.4 | Module17 | CCA1 | C | C | C | D |

| | | | | | | |
|---|---|---|---|---|---|---|
| Examp. : Example, Comp. : Comparative example, CCA: Close contact agent | | | | | | |

### INDUSTRIAL AVAILABILITY

According to the invention written in (1) and (11), when the circuit surface side of the IC chip is brought into close contact with the antenna formed on the module support and electrically connected to it, and the circuit surface side of the IC chip protects the IC chip with the module support, and even when the thickness is the same, 2 reinforcing plates are provided comparing to one reinforcing plate, the stress is distributed and the IC chip can be protected from damaging.

## Claims

1. IC card in which an IC module (3) including a module support and an IC chip (3a2) and an antenna (3a1), both mounted on the module support (3d), is incorporated together with an adhesive agent (3, 7) between a first base member (1) and a second base member (2),
**characterized in that**
the IC chip (3a2) has a circuit surface side (3a21) facing the module support (3d) and an opposite side surface (3a21) opposite to the circuit surface side (3a21), the IC card comprises a first resin layer (91) mounted on the opposite side surface (3a21) of the IC chip, a first reinforcing plate (3b) mounted on the first resin layer (91), a second resin layer (92) mounted on the first reinforcing plate (3b), a second reinforcing plate (3c) mounted on the second resin layer (92) and an adhesive agent layer (6) mounted on the second reinforcing plate (3c), wherein on electric circuit on the circuit surface side (3a21) is electrically connected with the antenna via an electric conductive member.

2. IC card of claim 1, **characterized in that** the first reinforcing plate (3b) is larger than a projected area of the IC chip (3a2) vertically projected onto the surface of the module support (3d), and a second reinforcing plate is larger than the projected area of the first reinforcing plate (3c) vertically projected onto the surface of the module support (3d).

3. IC card of claim 1, **characterized in that** the area of the second resin layer (92) is larger than the second reinforcing plate (3c).

4. IC card of one of claims 1 to 3, **characterized in that** the IC chip (3a2), the first reinforcing plate (3b), and the second reinforcing plate (3c) are fixed with the first and the second resin layer having a 2% elastic modulus of 0.1 to 55.0 kg/mm².

5. IC card of one of claims 1 to 4, **characterized in that** an image receiving layer (8a) is provided on at least one outer surface of the first base member (1) and the second base member (2) of the IC card and a writing layer (9a) is provided on the outer surface, and the Image receiving layer (8a) is located at an area of the outer surface under which the IC chip of the module supporter is not incorporated, and a writing layer (9a) is provided on the other outer surface, and the writing layer(9a) is located at on area of the outer surface under which the first reinforcing pilate (3b) and the second reinforcing plate (3c) are incorporated,

6. IC card of one of claims 1 to 5, **characterized in that** the thickness of the IC chip is 30 µm to 190 µm and a thickness of the resin layer (91, 92) is 1 µm to 50 µm.

7. IC card of one of claims 1 to 6, **characterized in that** the thickness of the module support (3d) on which the antenna (3a1) is formed is 10 µm to 50 µm and the maximum thickness of the IC chip section of the IC module is 350 µm or less.

8. IC cord of one of claims 1 to 7, **characterized in that** the positions of the center of gravity of the first reinforcing plate (3b) and the second reinforcing plate (3c) are almost the same with the position of the center of gravity of the IC chip, the shape of the first reinforcing plate (3b) is formed in circular or square with a metal and the shape of the second reinforcing plate (3c) is formed with a metal in square.

9. IC card of one of claims 1 to 8, **characterized in that** personal identification information including name and a face image is provided by fusing heat transferring or sublimation heat transferring onto the image receiving layer (8a).

10. IC card of one of claims 1 to 9, **characterized in that** the 2% elastic modulus of the adhesive agent is 1 to 80 kg/mm².

11. Method of manufacturing an IC card comprising:
electrically connecting an electric terminal provided on an IC chip circuit surface of the IC chip with an antenna provided on a module support with a conductive adhesive agent; thereafter,
potting a first resin layer on the IC chip and pressing with heat a first reinforcing plate onto the first resin layer;
potting a second resin layer on the first reinforcing plate and pressing with heat a second reinforcing plate onto the second resin layer, whereby producing an IC module; thereafter,
incorporating the IC module at a predetermined position between two base members,
filling an adhesive agent between the two base members:
and
pressing the two base members so as to come in close to each other.

## Patentansprüche

1. IC-Karte, in das ein IC-Modul (3), das einen Modulträger und einen IC-Chip (3a2) und eine Antenne (3a1) umfasst, die beide auf dem Modulträger (3d) befestigt sind, zusammen mit einem Klebstoff (3, 7) zwischen einem ersten Basiselement (1) und einem zweiten Basiselement (2) eingebracht ist,
**dadurch gekennzeichnet, dass**
der IC-Chip (3a2) eine dem Modulträger (3d) zugewandte Schaltungsoberflächenselte (3a21) und eine der Schaltungsoberflächenseite (3a21) gegenüberliegende Gegenseitenoberfläche (3a21) aufweist, die IC-Karte eine auf der Gegenseitenoberflüche (3a21) des IC-Chips befestigte erste Harzschicht (91), eine auf der ersten Harzschicht (91) befestigte erste Verstärkungsplatte (3b), eine auf der ersten Verstärkungsplatte (3b) befestigte zweite Harzschicht (92), eine auf der zweiten Harzschicht (92) befestigte zweite Verstärkungsplatte (3c) und eine auf der zweiten Verstärkungsplatte (3c) befestigte Klebstoffschicht (6) aufweist, wobei eine elektrische Schaltung auf der Schaltungsoberflächenseite (3a21) mit der Antenne über ein elektrisch leltfähiges Element elektrisch verbunden ist.

2. IC-Karte nach Anspruch 1, **dadurch gekennzeichnet, dass** die erste Verstärkungsplatte (3b) größer ist als eine projlzierte Fläche des IC-Chips (3a2), die vertikal auf die Oberfläche des Modulträgers (3d) proliziert ist, und eine zweite Verstärkungsplatte größer Ist als die projlzierte Fläche der ersten Verstärkungsplatte (3c), die vertikal auf die Oberfläche des Modulträgers (3d) projiziert ist.

3. IC-Karte nach Anspruch 1, **dadurch gekennzeichnet, dass** die Fläche der zwelten Harzschicht (92) größer als die zweite Verstärkungsplatte (3c) ist.

4. IC-Karte nach einem der Ansprüche 1 bis 3, **dadurch gekennzeichnet, dass** der IC-Chip (3a2), die erste Verstürkungsplatte (3b) und die zweite Verstärkungsplatte (3c) mit der ersten und der zweiten Harzschicht fixiert sind, die einen 2%-Elastizitätsmodul von 0.1 bis 55,0 kg/mm² aufweisen,

5. IC-Karte nach einem der Ansprüche 1 bis 4, **dadurch gekennzeichnet, dass** eine Bildaufnahmeschicht (8a) auf zumindest einer Außenoberfläche des ersten Basiselements (1) und des zwelten Basiselements (2) der IC-Karte vorgesehen ist, und eine Schreibschicht (9a) auf der Außanoberfläche vorgesehen ist, und die Bildaufnahmeschicht (8a) sich in einem Bereich der Außenoberfläche befindet, unter der der IC-Chip des Modulträgers nicht eingebracht ist, und eine Schreibschicht (9a) auf der anderen Außenoberfläche vorgesehen ist, und die Schreibschicht (9a) sich in einem Bereich der Außenoberfläche befindet, unter der die erste Verstärkungsplatte (3b) und die zweite Verstärkungsplatte (3c) eingebracht sind.

6. IC-Karte nach einem der Ansprüche 1 bis 5, **dadurch gekennzeichnet, dass** die Dicke des IC-Chips 30 µm bis 190 µm beträgt, und eine Dicke der Harzschicht (91, 92) 1 µm bis 50 µm beträgt.

7. IC-Karte nach einem der Ansprüche 1 bis 6, **dadurch gekennzeichnet, dass** die Dicke des Modulträgers (3d), auf dem die Antenne (3a1) ausgebildet ist, 10 µm bis 50 µm beträgt und die maximale Dicke des IC-Chipabschnitts des IC-Moduls 350 µm oder weniger beträgt.

8. IC-Karte nach einem der Ansprüche 1 bis 7, **dadurch gekennzeichnet, dass** die Positionen des Schwerpunkts der ersten Verstärkungsplatte (3b) und der zweiten Verstärkungsplatte (3c) beinahe dieselben sind, wie die Position des Schwerpunkts des IC-Chips, die Form der ersten Verstörkungsplatte (3b) mit einem Metall kreisförmig oder quadratisch ausgebildet ist, und die Form der zweiten Verstärkungsplatte (3c) mit einem Metall quadratisch ausgebildet ist.

9. IC-Karte nach einem der Ansprüche 1 bis 8, **dadurch gekennzeichnet, dass** persönliche Identifizierungsinformation einschließlich des Namens und eines Gesichtsbildes durch Schmelzwärmeübertragung oder Subllmationswärmeübertragung auf die Bildaufnahmeschicht (8a) vorgesehen ist.

10. IC-Karte nach einem der Ansprüche 1 bis 9, **dadurch gekennzeichnet, dass** der 2%-Elastlzitätsmodul des Klebstoffs 1 bis 80 kg/mm² beträgt.

11. Verfahren zur Herstellung einer IC-Karte, umfassend:
elektrisches Verbinden eines auf einer IC-Chipschaltungsoberfläche des IC-Chips vorgesehenen elektrischen Anschlusses, wobei eine Antenne auf einem Modulträger mit einem leitfähigen Klebstoff vorgesehen ist; dann:
Einkapseln einer ersten Harzschicht auf dem IC-Chip und Wärmepressen einer ersten Verstärkungsplatte auf die erste Harzschicht;
Einkapseln einer zweiten Harzschicht auf der ersten Verstärkungsplatte und Wärmepressen einer zweiten Verstärkungsplatte auf die zweite Harzschicht, wodurch ein IC-Modul hergestellt wird; dann:
Einbringen des IC-Moduls an einer vorbestimmten Position zwischen zwei Basiselementen.
Einfüllen eines Klebstoffs zwischen die zwei Basiselemente; und
Pressen der beiden Basiselemente, so dass sie sich aneinander annähern.

## Revendications

1. Carte à circuit intégré, dans laquelle un module à circuit intégré (3) comprenant un support de module et une puce de circuit intégré (3a2) et une antenne (3a1), les deux étant montées sur le support de module (3d), est inséré ensemble avec un adhésif (3, 7) entre un premier élément de base (1) et un deuxième élément de base (2),
**caractérisée en ce que**
la puce de circuit intégré (3a2) a une face de surface de circuit (3a21) faisant face au support de module (3d) et une face de surface opposée (3a21) qui se trouve opposée à la face de surface de circuit (3a21), la carte à circuit intégré comprend une première couche de résine (91) disposée sur la face de surface opposée (3a21) de la puce de circuit intégré, une première plaque de renforcement (3b) disposée sur la première couche de résine (91), une deuxième couche de résine (92) disposée sur la première plaque de renforcement (3b), une deuxième plaque de renforcement (3c) disposée sur la deuxième couche de résine (92) et une couche d'adhésif (6) disposée sur la deuxième plaque de renforcement ((3c), un circuit électrique sur la face de surface de circuit (3a21) étant relié électriquement à l'antenne par moyen d'un élément électroconducteur.

2. Carte à circuit intégré selon la revendication 1, **caractérisée en ce que** la première plaque de renforcement (3b) est plus grande qu'une partie en saillie de la puce de circuit intégré (3a2) qui fait verticalement saillie sur la surface du support de module (3d) et une deuxième plaque de renforcement est plus grande que la partie en saillie de la première plaque de renforcement (3c) qui fait verticalement saillie sur la surface du support de module (3d).

3. Carte à circuit intégré selon la revendication 1, **caractérisée en ce que** la surface de la deuxième couche de résine (92) est plus grande que la deuxième plaque de renforcement (3c).

4. Carte à circuit intégré selon l'une des revendications 1 à 3, **caractérisée en ce que** la puce de circuit intégré (3a2), la première plaque de renforcement (3b) et la deuxième plaque de renforcement (3c) sont fixées à la première et la deuxième couche de résine ayant un module d'élasticité de 2% qui est compris entre 0,1 et 55,0 kg/mm ².

5. Carte à circuit Intégré selon l'une des revendications 1 à 4, **caractérisée en ce qu'**une couche de réception d'images (8a) est prévue sur au moins une surface extérieure du premier élément de base (1) et du deuxième élément de base (2) de la carte à circuit intégré et une couche d'écriture (9a) est prévue sur la surface extérieure et la couche de réception d'images (8a) est placée dans une zone de la surface extérieure au-dessous de laquelle la puce de circuit intégré du support de module n'est pas insérée, et une couche d'écriture (9a) est prévue sur l'autre surface extérieure, et la couche d'écriture (9a) est placée dans une zone de la surface extérieure au-dessous de laquelle la première plaque de renforcement (3b) et la deuxième plaque de renforcement (3c) sont insérées.

6. Carte à circuit Intégré selon l'une des revendications 1 à 5, **caractérisée en ce que** l'épaisseur de la puce de circuit intégré est comprise entre 30 µm à 190 µm et l'épaisseur de la couche de résine (91, 92) est comprise entre 1 µm à 50 µm.

7. Carte à circuit intégré selon l'une des revendications 1 à 6, **caractérisée en ce que** l'épaisseur du support de module (3d) sur lequel l'antenne (3a1) est formée est comprise entre 10 µm et 50 µm et l'épaisseur maximale de la section de puce de circuit intégré du module à circuit intégré est 350 µm ou moins.

8. Carte à circuit intégré selon l'une des revendications 1 à 7, **caractérisée en ce que** les positions du centre de gravité de la première plaque de renforcement (3b) et de la deuxième plaque de renforcement (3) sont presque coïncidentes avec la position du centre de gravité de la puce de circuit intégré, la première plaque de renforcement (3b) étant réalisée en métal sous forme circulaire ou carrée et la deuxième plaque de renforcement (3c) étant réalisée en métal sous forme carrée.

9. Carte à circuit intégré selon l'une des revendications 1 à 8, **caractérisée en ce qu'**on fournit des informations d'identification personnelle comprenant le nom et une image de visage par transfert de chaleur de fusion ou transfert de chaleur de sublimation sur la couche de réception d'images (8a).

10. Carte à circuit intégré selon l'une des revendications 1 à 9, **caractérisée en ce que** le module d'élasticité de 2% de l'adhésif est compris entre 1 et 80 kg/mm².

11. Procédé de fabrication d'une carte à circuit Intégré comprenant les étapes de:
relier électriquement un terminal électrique prévu sur une surface de circuit de la puce de circuit intégré de la carte à circuit Intégré à une antenne prévue sur un support de module par moyen d'un adhésif conducteur ;
suivi de
couler une première couche de résine sur la puce de circuit intégré et presser avec chaleur une première plaque de renforcement sur la première couche de résine ;
couler une deuxième couche de résine sur la première plaque de renforcement et presser avec chaleur une deuxième plaque de renforcement sur la deuxième couche de résine en réalisant ainsi un module à circuit intégré ; suivi de
incorporer le module à circuit intégré à une position prédéterminée entre deux éléments de base,
mettre un adhésif entre les deux éléments de base ;
et
presser les deux éléments de base pour rapprocher l'un à l'autre.
